# EUROPEAN PATENT SPECIFICATION

(11) **EP 3 327 815 B1**
(45) Date of publication and mention of the grant of the patent: **06.11.2024**
(21) Application number: 16201206.6
(22) Date of filing: 29.11.2016
(51) Int. Cl.: H10K 50/30, H01S 5/125, H01S 5/36, H01S 5/12, H01S 5/30, H01S 5/062

(54) **LIGHT-EMITTING DEVICE**
LICHTEMITTIERENDE VORRICHTUNG
DISPOSITIF ÉLECTROLUMINESCENT

(43) Date of publication of application: 30.05.2018
(73) Proprietor: IMEC VZW, 3001 Leuven (BE); Katholieke Universiteit Leuven, 3000 Leuven (BE)
(72) Inventor: LEE, Jeong-Hwan, 3001 Leuven (BE); GENOE, Jan, 3001 Leuven (BE); HEREMANS, Paul, 3001 Leuven (BE); ROLIN, Cedric, 3001 Leuven (BE)
(74) Representative: AWA Sweden AB

(56) References cited:
- EP-A1- 2 858 116
- WO-A1-2013/122198

## Description

### Technical Field

The present invention relates to a light-emitting device. In particular, the present invention relates to a light-emitting transistor.

### Background

Organic light-emitting transistors (OLETs) combining dual functions of electrical switching and light emission are promising devices to push large amount of charge carriers into an isolated recombination area for intensive light generation beyond that of traditional Organic Light Emitting Diodes (OLEDs). OLETs have, therefore, the potential for intense light output, finding application in low-cost and high intensity displays and, ultimately, electrically pumped organic lasers.

OLETs differ from OLEDs by the use of a gate to mediate transport from injecting contacts to a radiative recombination zone. The gate is used to selectively accumulate charge carriers at an interface between a gate dielectric and a semiconducting transport material. A conductive channel formed by the semiconducting transport material is used to drive large amount of charge carriers over long distances (several µm) and into the recombination zone. In consequence, the use of a gate enables fast switching of the device at current densities that are orders of magnitude higher than usually achieved in OLEDs. Besides, the charge transport over long distance permits localization of the emissive recombination zone away from the injecting contacts, which is favorable to light output as it prevents contactinduced quenching phenomena.

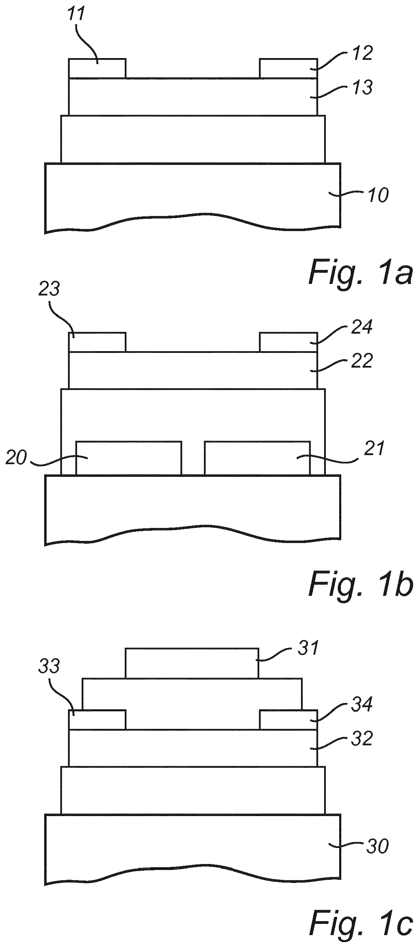

Many OLET device topologies and material combinations have been proposed in order to achieve efficient light emission and large driving currents. Referring now to Figs 1a-c, three different topologies will be discussed.

A topology similar to the topology shown in Fig. 1a is disclosed in M. Ullah et al, "Simultaneous Enhancement of Brightness, Efficiency, and Switching in RGB Organic Light Emitting Transistors", Advanced Materials, Vol. 25, pages 6213-6218 (2013). Fig. 1a shows a single gate architecture. An OLET device based on a single gate architecture may provide bright light emission, but suffers from hole-electron current imbalance when driven at high currents, despite the use of optimized organic transport layers with high mobilities. With the single gate architecture, a bias of a single gate 10 is used for forming channels for both types of charge carriers being injected by electrodes 11, 12 into an active layer 13. The simultaneous formation of accumulation channels of both p and n charge carriers by applying a bias on the single gate 10 is only possible if the threshold for accumulation of p-type carriers is far above that of n-type carriers. In such situation, which may be hard to achieve experimentally, there exists a moderate gate bias that enables balanced p- and n-type transport across the channel, creating a moderate ambipolar current. A major attraction of OLETs, however, is high light output. Ideally, this requires high densities of balanced currents that radiatively recombine in the center of the channel. In the single gate OLET architecture, such current balance can only be achieved at moderate accumulation of both types of charge carrier. In order to achieve high light output, single gate OLETs are usually driven far out of balance, by strongly biasing the single gate and transport only one species of carrier across the whole channel. In such case, the radiative recombination takes place in the vicinity of the electrode providing an injecting contact for the minority charge carrier. The proximity of the electrode is detrimental to efficient light emission because of significant leakage of the majority carrier into the contact and because of strong exciton and light quenching by the metal. In addition, in single gate OLETs, the emission zone can unpredictably switch from one contact to the other upon small bias changes since electron and hole currents are not controlled individually.

A topology similar to the topology shown in Fig. 1b is disclosed in N. Suganuma et al, "Organic light-emitting transistors with split-gate structure and PN-hetero-boundary carrier recombination sites", Organic Electronics, Vol. 9, pages 834-838 (2008). A topology similar to the topology shown in Fig. 1c is disclosed in W. S. C. Roelofs et al, "Fundamental Limitations for Electroluminescence in Organic Dual-Gate Field-Effect Transistors", Advanced Materials, Vol. 26, pages 4450-4455 (2014). Fig. 1b shows a split-gate architecture and Fig. 1c shows an opposing gate architecture. In both these architectures, two gates are used to independently control transport of electrons and holes. The use of an additional gate compared to the single gate architecture offers a new degree of freedom to decouple the p- and n-type currents and simultaneously achieve balanced transport at high current density.

The split-gate OLET provides two gates 20, 21 on the same side of an active layer 22 for forming channels for charge carriers being injected by electrodes 23, 24, respectively, into the active layer 22. The split gate OLET architecture may place the emission zone far from the injecting metal electrodes. Unfortunately, it is difficult to manufacture a split-gate OLET device with a small spatial gap between the split gates 20, 21. Thus, typically a gap of about 1 µm between the split gates 20, 21 will be present, which complicates transport of large currents since a significant length of the channel in the active layer is not gated and therefore highly resistive.

The opposing-gate OLET provides two gates 30, 31 on opposite sides of the active layer 32 for forming channels for charge carriers being injected by electrodes 33, 34, respectively, into the active layer 32. The opposing-gate OLET permits balanced hole and electron currents. However, an electric field present between the opposing gates is pulling electron and holes apart and strongly opposes charge injection for causing recombination into a central portion of the active layer between the opposing gates.

There is thus a need for improvement of the architecture for light-emitting transistors.

WO2013122198 A1 discloses a light-emitting transistor which contains an organic semiconductor material and has improved light emission efficiency, and a light-emitting device which includes said light-emitting transistor. This light-emitting transistor, which includes an additional electrode between a gate insulating layer and an organic semiconductor layer, has improved light emission efficiency. Regarding conductivity of the additional electrode, if the sheet resistance is less than or equal to 10 kOmega/sq., then light emission efficiency is further improved. Because this light-emitting device includes the aforementioned organic light-emitting transistor having an additional electrode, light emission efficiency may be improved.

EP 2858116 A1 discloses an ambipolar transistor device comprising a semiconductor layer, a plurality of control electrodes and two or more charge transport electrodes. The charge transport electrodes include at least a source electrode and a drain electrode, and the control electrodes include a gate electrode. The charge transport electrodes are located in the device such as to be in contact with the semiconductor layer. The control electrodes are arranged such as to be electrically insulated from the semiconductor layer by an insulating layer. The control electrodes further comprise at least one auxiliary electrode, wherein the auxiliary electrode and the gate electrode are located in relation to the semiconductor layer at a same side thereof. The semiconductor layer is an ambipolar semiconductor layer comprising an ambipolar semiconductor material. The auxiliary electrode includes at least one of an auxiliary source electrode or an auxiliary drain electrode, to control for in use controlling the polarity of the ambipolar transistor by suitable charging biasing of the control electrodes such as to control charge concentrations and charge injection in said semiconductor layer.

### Summary of the Invention

An objective of the present inventive concept is therefore to provide an improved light-emitting transistor. It is a particular objective of the present inventive concept to provide a light-emitting transistor that allows output of light of high intensity.

These and other objectives of the present inventive concept are at least partially met by the invention as defined in the independent claims. Preferred embodiments are set out in the dependent claims.

According to a first aspect, there is provided a light-emitting device, comprising: an active layer comprising at least one semiconductor layer for transport of charge carriers and emission of light upon radiative recombination of charge carriers of a first type and a second type, a first gate layer, which is arranged to control density of charge carriers of the first type in the active layer, a second gate layer, which is arranged to control density of charge carriers of the second type in the active layer, wherein a first insulating layer is arranged on the first gate layer and the second gate layer forms a pattern on the first insulating layer, wherein a second insulating layer is arranged on the second gate layer, wherein the active layer is arranged on the first and second insulating layers, and
wherein the first gate layer and the second gate layer are configured to independently accumulate the respective type of charge carrier, enabling opening of two balanced unipolar channels that independently drive charge carriers into a zone of the active layer where radiative recombination occurs.

Thanks to the invention, it is possible to separately design the first and the second gate layers by means of the first insulating layer being arranged between the first and the second gate layers. This implies that each of the first gate layer and the second gate layer may be freely designed in the architecture. The two gates are independently used to accumulate a respective type of charge carrier, enabling opening of two balanced unipolar channels that independently drive charge carriers into a zone of the active layer where radiative recombination occurs. Since the second gate layer is arranged on the first insulating layer, the second gate layer could be arranged to overlap the first gate layer (as seen from above along a direction of a normal to the layers). In such overlapping arrangement, the architecture may ensure that charge carriers are transported in the active layer with a high density of charge carriers throughout a channel in the active layer to the radiative recombination zone.

Also, thanks to the active layer being arranged on both the first and the second gate layer, electrons and holes are not pulled apart in the active layer, such that a high density of both types of charge carriers may be formed in a radiative recombination zone.

Thanks to the light-emitting device, it is therefore possible to provide current balance up to high current levels, transport charge carriers through a densely accumulated channel and isolate a radiative recombination zone from the electrodes which may act to quench light emission. Hence, the light-emitting device enables achievement of high external quantum efficiency (EQE) at high currents, and therefore high light output.

It should be realized that the second gate layer need not necessarily be arranged to overlap the first gate layer. However, the second gate layer may be freely designed such that it is possible to arrange the second gate layer to overlap with the first gate layer, which may be beneficial in ensuring transport of charge carriers into the radiative recombination zone.

In the context of this application, a layer being arranged "on" or "above" another layer should not be construed as the layers being arranged in a certain relationship with respect to an external reference (such as the earth). Rather, the term should be construed to define an internal relationship between the layers within the structure of the light-emitting device, which may for instance be related to an order in which the layers are formed on any surface of a substrate (top, bottom or side surfaces). Thus, if the light-emitting device is arranged so that the layers form a vertical stack, a layer being "on" another layer indicates that the layer is an upper layer in the stack. Further, the layers being arranged such that one layer is on another layer may or may not have the same extension in a horizontal plane.

In the context of this application, the second gate layer forming a pattern on the first insulating layer should be construed as the second gate layer not completely covering the first insulating layer. Rather, the second gate layer has a different extension in a horizontal plane (if the structure is arranged as a vertical stack). Further, the term "forming a pattern" should only be construed as to define a relation between the layers and should not imply any limitation as to manufacturing steps in order to create the second gate layer.

According to an embodiment, the second gate layer forms a pattern above the first gate layer such that at least part of the second gate layer overlaps the first gate layer. This implies that if the second gate layer is projected onto a plane in which the first layer is arranged, the at least part of the second gate layer would coincide with the first gate layer. In other words, the overlap implies that the second gate layer superposes the first gate layer in a vertical direction orthogonal to substrate of the light-emitting device. Thanks to this arrangement, the first and the second gate layers may be formed in relation to the active layer so as to ensure that transport of charge carriers is achieved to a radiative recombination zone in the active layer also overlapping with the at least part of the second gate layer which overlaps the first gate layer.

The second gate layer could form a pattern such that the entire second gate layer overlaps the first gate layer. Hence, the second gate layer may have a smaller extension than the first gate layer. However, such an arrangement may not be optimal, as the first gate layer beneath the second gate layer may affect the density of charge carriers of the second type in the active layer.

The second gate layer may form a pattern such that the second gate layer overlaps only part of the first gate layer. This implies that a portion of the first gate layer is not overlapped by the second gate layer. This portion of the first gate layer may then be arranged to control the density of charge carriers of the first type in the active layer overlapping this portion of the first gate layer.

The second gate layer may comprise an edge arranged above the first gate layer, wherein said edge defines a gate overlapping line along the edge. As used in the context of this application, the term "gate overlapping line" should thus be construed as an edge of an overlapping area of the second gate layer and the first gate layer, as viewed from above the light-emitting device along a direction of a normal to the layers. The gate overlapping line may thus follow an edge of the second gate layer that overlaps with the first gate layer. The gate overlapping line may have different shapes (straight or non-straight) and may even be discontinuous based on a pattern of the second gate layer and/or a pattern of the first gate layer as will be further described below.

According to an embodiment, the light-emitting device further comprises a first electrode in contact with the active layer for injecting charge carriers of the first type into the active layer and a second electrode in contact with the active layer for injecting charge carriers of the second type into the active layer.

The electrodes may be arranged on the active layer, which may be beneficial in order to inject charge carriers into the active layer at a side of the electrode facing the gate layer. However, the active layer may alternatively be arranged on the electrodes, such that the electrode is arranged between the active layer and the gate layer.

Also, according to an embodiment, one of the first and second electrodes may be arranged on the active layer, whereas the active layer may be arranged on the other of the first and second electrodes.

According to another embodiment, the first electrode is arranged to inject charge carriers of a first type into a first semiconductor layer of the active layer and the second electrode is arranged to inject charge carriers of a second type into a second semiconductor layer of the active layer. In one embodiment, the first electrode may be arranged in relation to the first semiconductor layer, such as on or below the first semiconductor layer, whereas the second electrode may be arranged in relation to the second semiconductor layer, such as on or below the second semiconductor layer. The first and second electrodes need thus not be arranged on or below the same layers of the active layer and placement of each electrode may be adapted to provide desired characteristics for injection of charge carriers into the active layer. The first and second electrodes may be arranged in any relation to the respective first and second semiconductor layers, such that the electrode may or may not be between the semiconductor layer of the active layer and the gate layer.

In one embodiment, the first electrode and the second electrode may be arranged in contact with the first semiconductor layer and the second semiconductor layer, respectively. Also, one or more dopant layers may be formed in an interface between the electrode and the semiconductor layer so as to promote charge injection into the semiconductor layer.

According to an embodiment, the active layer comprises at least a first semiconductor layer for transport of charge carriers of the first type and a second semiconductor layer for transport of charge carriers of the second type. The first and the second semiconductor layer may thus be specifically adapted for transport of charge carriers of the first and the second type, respectively.

According to an embodiment, the active layer further comprises a third semiconductor layer for the radiative recombination of charge carriers of the first and second types. Thus, the third semiconductor layer may be adapted to provide a high EQE generated from the recombination of charge carriers in the third semiconductor layer.

Thanks to the active layer comprising a first, second and a third semiconductor layer, the respective layers may be adapted in relation to desired characteristics for the layers. However, it should be realized that the active layer need not be formed from three layers but may be formed from other number of layers, such as a single layer, two layers or even more than three layers. Also, the first, second and third semiconductor layers of the active layer may each be formed by one or more layers.

According to an embodiment, at least one of the first semiconductor layer and the second semiconductor layer forms a pattern to extend in a direction from a first one of the first or the second electrode towards a second one of the first or the second electrode, wherein the pattern of the at least one of the first semiconductor layer and the second semiconductor layer extends to overlap an edge of the second gate layer and ends such that the second one of the first or the second electrode and the at least one of the first semiconductor layer and the second semiconductor layer do not overlap.

The edge of the second gate layer may define an edge of overlap between the second gate layer and the first gate layer and hence, a radiative recombination zone in the active layer may be arranged above this edge. By means of the first semiconductor layer extending from the first electrode to overlap this edge of the second gate layer, the first semiconductor layer may provide a transport channel of charge carriers of the first type from the first electrode to the radiative recombination zone. By the first semiconductor layer further ending such that the second electrode and the first semiconductor layer do not overlap, the first semiconductor layer (which transports charge carriers of the first type) may not be affected by the second electrode, which is intended to provide injection of charge carriers of the second type into the second semiconductor layer. The second semiconductor layer may also or alternatively be arranged in a similar manner for providing a transport channel of charge carriers of the second type from the second electrode to the radiative recombination zone without being affected by the first electrode.

According to an embodiment, the third semiconductor layer forms a pattern to extend on opposite sides of an edge of the second gate layer between the first and second electrode such that at least one of the first and second electrode and the third semiconductor layer do not overlap. Thus, the radiative recombination zone may be formed in the third semiconductor layer on opposite sides of the edge of the second gate layer. The third semiconductor layer may be adapted for radiative recombination of charge carriers and may thus not be involved in the main transport of charge carriers from the electrodes to the radiative recombination zone. Hence, the third semiconductor layer may be arranged such that the electrodes and the third semiconductor layer do not overlap and the third semiconductor layer is not affected by the electrodes.

According to an embodiment, the first gate layer forms a pattern on a substrate, such that an overlap of the first gate layer and the second gate layer is defined by an edge of the first gate layer and an edge of the second gate layer. This implies that both the first gate layer and the second gate layer may be patterned. Hence, the device may be arranged such that there is a small area in which the first and the second gate layers overlap. Also, the device may be arranged such that there is small or no overlap between the first electrode and the first gate layer and the second electrode and the second gate layer, respectively. This implies that the device may be less subject to parasitic capacitance.

Also, as the first gate layer forms a pattern on a substrate, the light-emitting device may be formed on any substrate allowed by a temperature budget for manufacturing the device. Thus, the light-emitting device may be formed on glass and flexible substrates such as papers, thin metal foils, plastic foils, textiles, etc.

According to an embodiment, at least the second gate layer forms a pattern so that a non-straight gate overlapping line is defined. If both the first and the second gate layers are patterned, the relation of the patterns to each other may define the gate overlapping line. Using a non-straight gate overlapping line a radiative recombination zone may be spread out in the light-emitting device and an emission line in the active layer corresponding to the gate overlapping line may be longer than a device channel width, i.e. a dimension of the light-emitting device in a direction in the active layer perpendicular to an extension of the active layer between the first and the second electrode.

According to an embodiment, at least the second gate layer forms a pattern to define the gate overlapping line in relation to the active layer such that the active layer is arranged discontinuously above the gate overlapping line. This implies that a radiative recombination zone may be limited to sections where the active layer is arranged above the gate overlapping line and hence, a concentration of light emission may be provided in such sections.

According to an embodiment, the first gate layer and the second gate layer each form a pattern including protrusions, such that protrusions of the first gate layer pattern and protrusions of the second gate layer pattern extend towards each other when viewed from above the first and second gate layers such that an overlap between the first gate layer and the second gate layer is formed at ends of the protrusions defining a discontinuous gate overlapping line.

The discontinuous gate overlapping line may imply that light emission may be concentrated to sections of the active layer above the overlap between the first gate layer and the second gate layer. In fact, if pointed protrusions of the first and second gate layer patterns are used, the overlap of the active layer with the discontinuous gate overlapping line may constitute one or more small spots from which light is emitted.

Also by regularly spacing out the areas of light emission, resonant modes for the emitted light may be sustained in the device. To this end, a pitch distance separating arrayed emissive regions may be a multiple of the wavelength of the emitted light.

According to an embodiment, the active layer extends between a first and a second electrode and the light-emitting device further comprises resonating structures at opposite sides of the active layer for resonating emitted light in a direction which is orthogonal to a direction between the first and the second electrode.

The light-emitting device provides a possibility to enable high intensity light output. By means of arranging resonating structures at opposite sides of the active layer, the light-emitting device may further be arranged to provide stimulated emission of radiation and thus form a laser. The resonating structures may be arranged at an upper and a lower side, respectively, of the active layer. Thus, the stimulated emission of radiation may be output through a top surface of the active layer. Alternatively, the resonating structures may be arranged at horizontal sides of the active layer and the stimulated emission of radiation may then be output through a side of the active layer. The resonating structures may be formed in the active layer at sides of the active layer, or may be formed in layers adjacent to the active layer.

According to a second aspect of the invention, there is provided a light-emitting device for stimulated emission of radiation, said device comprising: an active layer comprising at least one semiconductor layer for transport of charge carriers to a radiative recombination zone, a first gate layer, which is arranged to control density of charge carriers of a first type in the active layer, a second gate layer, which is arranged to control density of charge carriers of a second type into the active layer, wherein an insulating layer is arranged on the first gate layer and the second gate layer forms a pattern on the insulating layer, wherein the active layer is arranged on the first and second gate layers, wherein the radiative recombination zone is formed in the active layer between a first electrode for injecting charge carriers of the first type into the active layer and a second electrode for injecting charge carriers of the second type into the active layer, and wherein the light-emitting device is provided with a periodic structure of alternating high refractive index region and low refractive index region along opposite sides of the active layer between the first and the second electrode, said periodic structure providing a feedback of light emitted from the radiative recombination zone back into the radiative recombination zone for stimulating emission of radiation.

Thanks to the second aspect of the invention, use is made of the structure of gate layers and an active layer so as to provide effective transport of charge carriers to a radiative recombination zone for high intensity light output. Based on this structure, a resonating structure is added for providing feedback of emitted light back into the radiative recombination zone so as to stimulate emission of radiation and allowing the light-emitting device to output laser light. Thus, a low-cost and compact laser device may be provided, which may be very useful in a number of applications.

### Brief Description of Drawings

The above, as well as additional objects, features and advantages of the present inventive concept, will be better understood through the following illustrative and non-limiting detailed description of preferred embodiments of the present inventive concept, with reference to the appended drawings. In the drawings like reference numerals will be used for like elements unless stated otherwise.
Figs 1a-c are cross-sections of topologies for light-emitting devices according to prior art.
Figs 2a-f are cross-sections illustrating topologies of a light-emitting device according to different embodiments of the invention.
Figs 3a-b are top views of a light-emitting device according to different embodiments illustrating patterning of a second gate layer and patterning of first and second electrodes.
Fig. 4 is a top view of a light-emitting device according to an embodiment illustrating patterning of a second gate layer for patterning a gate overlapping line.
Figs 5a-d are top views of a light-emitting device according to different embodiments illustrating patterning of an active layer in relation to the patterning of a second gate layer.
Figs 6a-f are top views of a light-emitting device according to different embodiments illustrating patterning of a first and a second gate layer for patterning of a gate overlapping line.
Fig. 7 is a schematic view illustrating band diagram and alignments of layers within an active layer of the light-emitting device.
Figs 8a-b are schematic views illustrating a topology of a light-emitting device for providing stimulated emission of radiation.
Figs 9a-c are charts illustrating electrical and optical characteristics of a red-emitting opposite gate organic light-emitting transistor according to a first example.
Fig. 9d is a schematic view illustrating an emissive zone of the device of the first example.
Figs 10a-c are charts illustrating electrical and optical characteristics of a red-emitting opposite gate organic light-emitting transistor according to a first example.
Fig. 10d is a schematic view illustrating an emissive zone of the device of the first example.

### Detailed Description

Detailed embodiments of the present invention will now be described with reference to the drawings.

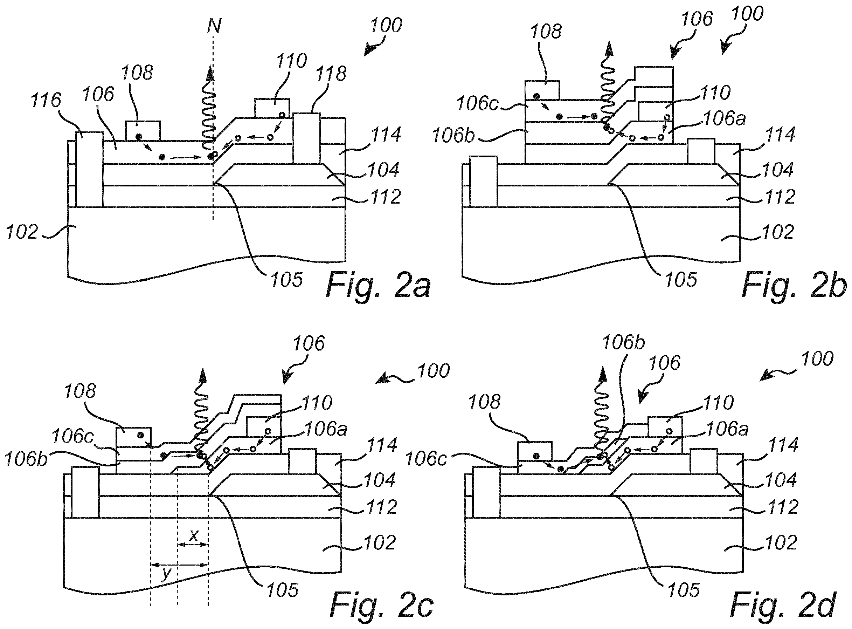

Referring now to Fig. 2a, a light-emitting device 100 will first be generally described. The light-emitting device 100 may be formed as a semiconductor structure and may thus be manufactured by forming of multiple layers on a substrate.

The light-emitting device 100 comprises a first gate layer 102 and a second gate layer 104. The light-emitting device 100 also comprises an active layer 106. A first electrode 108 may be arranged above the first gate layer 102 and a second electrode 110 may be arranged above the second gate layer 104. The first gate layer 102 may be biased in order to open a conductive channel of charge carriers of a first type in the active layer 106. The first electrode 108 may be biased in order to inject charge carriers of this first type into the active layer 106. Similarly, the second gate layer 104 and the second electrode 110 may be biased in order to open a conductive channel and inject charge carriers of a second type in the active layer 106. The active layer 106 may thus be arranged to transport the charge carriers of the first and second types towards each other in the active layer 106 so that the charge carriers may meet and recombine in the active layer 106 while emitting light.

A first insulating layer 112 is arranged on the first gate layer 102 and second gate layer 104 is arranged on the first insulating layer 112. Thus, the second gate layer 104 may be separately formed and patterned from the first gate layer 102 as the first and the second gate layers 102, 104 are separated by the first insulating layer 112.

A second insulating layer 114 is formed on the second gate layer 104 and the active layer 106 may be arranged on the second insulating layer 114 such that the active layer 106 is arranged over both the first gate layer 102 and the second gate layer 104 and the first and the second gate layers 104 may be respectively biased to open channels in the active layer 106.

Thanks to the arrangement, the first gate layer 102 and the second gate layer 104 may be freely designed with respect to each other. Thus, the respective gates formed by the first gate layer 102 and the second gate layer 104 may be separately designed in order to control accumulation and transport of charge carriers of the respective types in the active layer 106. Thus, a high current of each type of charge carrier may be achieved in the active layer 106 and charge carriers of the first and the second types may be transported towards each other in the active layer 106 so that the charge carriers may radiatively recombine in a radiative recombination zone in the active layer 106 between the electrodes 108, 110.

The first and second gate layers 102, 104 may be both arranged so as to extend from an electrode 108, 110 to the radiative recombination zone in order to control transport of the charge carrier in the active layer 106 from the electrode 108, 110 to the radiative recombination zone. In order to facilitate that the charge carriers meet in the radiative recombination zone in the active layer 106, the first and second gate layer 102, 104 may be arranged to overlap (as seen from above along a direction of a normal to the layers, as indicated by line N in Fig. 2a) or at least very close to each other. This is possible as the first and the second gate layers 102, 104 are separated by the first insulating layer 112.

The overlap between the second gate layer 104 and the first gate layer 102 may be defined by an edge 105 of the pattern of the second gate layer 104 that overlaps with the first gate layer 102. This edge 105 may define a gate overlapping line, which is a line in a plane of the second gate layer 104. A position of the gate overlapping line in the structure of the light-emitting device 100 in Fig. 2a is indicated by line N, which is a normal to the layers and intersects with the gate overlapping line.

Now referring specifically to Fig. 2a, a first embodiment of the light-emitting device 100 shown therein will be described in more detail. The light-emitting device 100 comprises a first gate layer 102. A conducting substrate 102 may be used as the first gate layer 102. However, as will be exemplified below, the first gate layer 102 may be arranged on the substrate and may be separate from the substrate.

The light-emitting device 100 further comprises a first insulating layer 112, which is arranged on the first gate layer 102. The first insulating layer 112 may be formed from a thin dielectric film.

The light-emitting device 100 further comprises a second gate layer 104, which may be deposited and patterned to overlap only over a portion of the first gate layer 102.

The light-emitting device 100 further comprises a second insulating layer 114, which may be formed from a dielectric film. The second insulating layer 114 may be arranged to cover both the second gate layer 104 and the first insulating layer 112, as this would mean that the second insulating layer 114 may be easily formed on the substrate as no patterning of the second insulating layer 114 may be needed.

An active layer 106 is arranged on the second insulating layer 114. The active layer 106 may be a single layer for transport of charge carriers and emission of light upon radiative recombination of the charge carriers. However, the active layer 106 may also comprise a plurality of layers for different purposes as will be explained further below.

The electrodes 108, 110 for injecting charge carriers into the active layer 106 are patterned on the active layer 106. The first electrode 108 is located above the first gate layer 102 and the second electrode 110 is located above the second gate layer 104. Different metals/doping layers can be used to form the first electrode 108 and the second electrode 110 in order to facilitate injection of the charge carrier into the active layer 106.

The first gate layer 102 may be biased in order to open a conductive channel of one type of charge carriers, e.g. n-type charge carriers. The first electrode 108 may be biased in order to inject this charge carrier into the active layer 106. Equivalently, the second gate layer 104 and the second electrode 110 may be biased in order to open a channel and inject the other type of charge carrier, e.g. p-type charge carriers, into the active layer 106. The biases applied to the first electrode 108 and the second electrode 110 create a lateral electric field that yields a drift current of both types of charge carriers towards the center of the channel in the active layer 106 between the electrodes 108, 110 and above the gate overlapping line. The recombination zone is mainly located at a location in the active layer 106 above the gate overlapping line, far away from the injecting electrodes 108, 110. The transport of a charge carrier beyond a location in the active layer 106 above the gate overlapping line is limited by the recombination with the other type of charge carrier that exists in majority in that region.

It should be realized that the first gate layer 102 and the first electrode 108 may instead be biased in order to open a channel and inject the other type of charge carrier, e.g. p-type charge carriers, into the active layer 106. The second gate layer 104 and the second electrode 110 may then be biased in order to open a channel and inject the first type of charge carrier, e.g. n-type charge carriers, into the active layer 106.

The light-emitting device 100 may further comprise some via holes 116, 118, which may be patterned through the dielectric layers in order to contact the first gate layer 102 and the second gate layer 104, respectively.

One or more of the semiconductor layers of the light-emitting device 100 may be formed by organic semiconductor layers. The light-emitting device 100 may thus form an organic light-emitting transistor (OLET), which may emit light with high intensity through a low-cost device. Thus, the light-emitting device 100 may for instance find application in high intensity displays or even in laser applications, as explained further below. At least some of the semiconductor layers need not be formed from an organic compound, while the light-emitting device 100 may still provide the benefits of output of high intensity light in a low-cost device. Thus, even though no semiconductor layer is necessarily organic, as will be exemplified below, the light-emitting device 100 may be referred to as an OLET below, as the device at least enables use of organic semiconductor layers for providing a light-emitting transistor.

Further, as mentioned above, the second gate layer 104 may be arranged to overlap the first gate layer 102, which is enabled by the first insulating layer 112 being arranged therebetween. Although the second gate layer 104 need not necessarily be arranged to actually overlap the first gate layer 102, the light-emitting device structure may be referred to as an overlapping gate OLET, OG-OLET below.

In the OLET configuration of Fig. 2a, a careful adjustment of the biases set on the first gate layer 102, the second gate layer 104, the first electrode 108 and the second electrode 110 enables to balance hole and electron currents. This independent control can be achieved up to high total current levels. A balanced recombination process, even at high currents, guarantees less adverse quenching events and an emission located far away from the injecting electrode contacts. All of these concur to a device that is more efficient at higher current levels.

The configuration in Fig. 2a is relatively simple. However, many degrees of freedom exist in the device architecture, opening many routes for optimization of the light-emitting device 100 as will be explained below. In addition or alternatively, material choice and optimization may also be used to ensure an efficient OLET operation. This will also be discussed below.

In order to improve the OG-OLET device performance, the simple structure shown in Fig. 2a can be further sophisticated through a number of improvements.

Fig. 2a shows a single active layer 106 that combines the functions of ambipolar transport and radiative recombination. Some organic semiconductors, such as tetracene polycrystalline films, poly(9,9-dioctylfluorene-alt-benzothiadiazole) also known as F8BT polymer, and 5,5"-bis(biphenylyl)-2,2':5',2"-terthiophene (BP3T) single crystals, may combine these functions with reasonable efficiency.

However, as shown in Fig. 2b, the active layer 106 may instead use a plurality of layers, which may be specialized to a specific function. Thus, such a configuration may facilitate higher efficiencies.

As shown in Fig. 2b, the active layer 106 may comprise a hole transporting layer (HTL) 106a, an emissive layer (EML) 106b, and an electron transporting layer (ETL) 106c.

The role of the two transport layers 106a, 106c is to efficiently deliver charge carriers injected from the two electrodes to the recombination zone above the gate overlapping line. This may be facilitated by the application of correct biases to the first gate layer 102, the second gate layer 104, the first electrode 108 and the second electrode 110.

The role of the EML 106b is to ensure that in the recombination zone above the gate overlapping line, the recombination occurs through an efficient radiative process.

The multilayer topology of the active layer 106 enables a separation of the functions: As explained below in discussion of material choices, each material may be selected for its ability to fulfill one specialized function. Besides, by spacing out charge transport- and emission paths, lower polaronexciton quenching can be expected in this embodiment.

Fig. 2b shows one possible combination of the multilayer topology of the active layer 106, namely HTL/EML/ETL. It should however be realized that other combinations of the multilayer topology of the active layer 106 may be used. Using a multilayer stack in the combinations ETL/EML/HTL, ETL/HTL/EML, HTL/ETL/EML, EML/HTL/ETL, EML/ETL/HTL can also achieve effective light emission, while also adapting materials, layout of electrodes and biasing conditions to the choice of topology of the active layer 106.

It should also be realized that the first gate layer 102 and the first electrode 108 may alternatively be arranged for injecting holes into the HTL 106a and the second gate layer 104 and the second electrode 110 may then be arranged for injecting electrons into the ETL 106c. However, for simplicity, the first gate layer 102 and first electrode 108 are described below as injecting electrons into the ETL 106c, whereas the second gate layer 104 and the second electrode 110 are described as injecting holes into the HTL 106a.

Fig. 2a shows both injecting electrodes 108, 110 formed on top of the active layer 106. This symmetrical configuration is simple to fabricate but is not necessarily ideal for the injection of both types of charge carriers. In contrast, the OG-OLET in Fig. 2b has asymmetric electrodes 108, 110. The materials of the first electrode 108 and the second electrode 110 are not necessarily of the same nature and it may thus be suitable to form the first and the second electrodes 108, 110 in separate steps. If the first and the second electrodes 108, 110 are anyway formed in separate steps they may also be asymmetrically arranged in the OG-OLET topology.

Thus, as shown in Fig. 2b, the first electrode 108 may be formed above the ETL 106c, while the second electrode 110 may be formed above the HTL 106a. This electrode asymmetry in material and positioning may be used to achieve efficient injection of electrons and holes into the ETL 106c and HTL 106a, respectively. Depending on the choice of topology, of active materials, and of biasing conditions, different materials and positioning of the electrodes 108, 110 can be used in order to enhance the injection characteristics.

For example, the second electrode 110 on the HTL 106a in Fig. 2b can be placed under the HTL 106a or on top of the EML 106b or the ETL 106c. The first electrode 108 on the ETL 106c in Fig. 2b can also be formed on top of the EML 106b or the HTL 106a, or under the HTL 106a, separately. Choice of material for electrodes 108, 110 may be guided by formation of a low energy barrier between the work function of the electrode 108, 110 and the transport energy level of material in the active layer 106, as detailed further below.

It may be advantageous to decrease or minimize parasitic leakage current flowing from one injecting electrode contact to the other, as parasitic leakage current does not particpate in the radiative recombination process. A parasitic leakage path may be made possible when at least one of the two transport layers 106a and 106c connects the two electrodes 108 and 110. In such a case, conduction paths for each type of charge carrier at different interfaces can be created that are separate from the recombination current path. Charge carriers lost to these leakage paths do not participate in light emission, and thereby an overall device efficiency may be reduced. This parasitic leakage may be reduced by forming a pattern for at least one of the transporting layers 106a, 106c. In Fig. 2c, a patterning of the HTL 106a is shown.

The patterned HTL 106a as shown in Fig. 2c extends from the second electrode 110 to overlap an edge 105 of the second gate layer 104. Thus, the HTL 106a extends to overlap the gate overlapping line, and the HTL 106a thereby extends to the radiative recombination zone. The HTL 106a can be extended slightly beyond the gate overlapping line, but may end such that the first electrode 108 and the HTL 106a do not overlap. The HTL 106a may thus end far from an edge of the first electrode 108. In other words, a distance *x* indicated in Fig. 2c representing an extension of the HTL 106a from the gate overlapping line towards the first electrode 108 could be larger than 0, but shorter than a distance y that corresponds to the distance from the gate overlapping line to the edge of the first electrode 108.

Instead of the patterning of the HTL 106a, the ETL 106c could be patterned in a similar fashion, extending from the first electrode 108 to overlap an edge 105 of the second gate layer 104, but may end such that the ETL 106c and the second electrode 110 do not overlap.

Furthermore, multiple combinations of active layer patterning may be contemplated and can be used to improve efficiency of the OG-OLET. For instance, in Fig. 2d, another possible topology is shown, where the EML 106b is limited to a narrow region extending on opposite sides of and above the gate overlapping line and ending far from both the first electrode 108 and the second electrode 110. In the example of Fig. 2d, the topology of the active layer 106 may contribute to lower trapping of the electrons in the ETL 106c by lower energy sites in the EML 106b. Further, much of the charge transport may then occur at an interface between the second insulating layer 114 and the ETL 106c, which can be engineered to provide better transport.

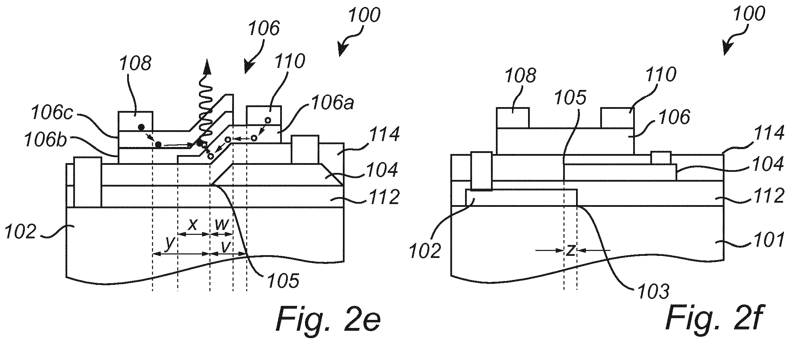

In Fig. 2e, another possible topology is shown where all three semiconductor layers 106a-c of the active layer 106 are patterned. In this embodiment, the transport layers 106a, 106c both extend from their respective injecting electrode 110, 108 to the radiative recombination zone above the gate overlapping line but both transport layers 106a, 106c end before reaching the opposite electrode 108, 110, respectively, in order to prevent leakage currents. Further, in this embodiment, the EML 106b may be patterned along with the ETL 106c, so that patterning of both these layers may be performed in a single patterning step.

In the embodiment of Fig. 2e, the EML 106b and the ETL 106c may thus end far from an edge of the second electrode 110. In other words, a distance w in Fig. 2e representing an extension of the ETL 106c from the gate overlapping line towards the second electrode 110 could be larger than 0, but shorter than a distance v, that corresponds to the distance from the gate overlapping line to an edge of the second electrode 110.

The simple structure of the embodiment in Fig. 2e provides a constant electron accumulation and transport at the ETL/EML interface and a confinement of the radiative recombination zone above the gate overlapping line. Also, the outer edges of the active layer 106 may anyway need to be patterned in order to confine current transport in the area of the light-emitting device 100 and thereby limit leakage paths outside of the light-emitting device 100, e.g. if the light-emitting device 100 is arranaged in an array of light-emitting devices 100 on the substrate.

As shown in Fig. 2f, the first gate layer 102 may be arranged on the substrate 101. In such an embodiment, the first gate layer 102 may form a pattern on the substrate 101, which increases a freedom of design of a relation between the first gate layer 102 and the second gate layer 104.

As shown in Fig. 2f, the two gate layers 102, 104 may be patterned to have an overlap with a small area between an edge 103 of the first gate layer 102 and an edge 105 of the second gate layer 104, indicated by arrow z in Fig. 2f.

A light-emitting device 100 having a first gate layer 102 and a second gate layer 104 forming a pattern enables the light-emitting device 100 to have an architecture with a reduced gate-gate overlap area as well as reduced gate-electrode overlap area (i.e. overlap of first electrode 108 with first gate layer 102 or overlap of second electrode 110 with second gate layer 104). Such architecture of the light-emitting device 100 is less subject to parasitic capacitance. The topology in Fig. 2f illustrated a small gate-gate overlap, which is already beneficial, but it should be realized that the topology may be further adapted to provide a reduced gate-electrode overlap. Such a light-emitting device 100 can be driven at higher frequencies, which is of interest for many practical applications.

Further, as the first gate layer 102 becomes a layer independent of the substrate 101, the OG-OLET device 100 can be processed on virtually any substrate 101 allowed by the temperature budget set by the deposition of the layers composing the OG-OLET device. Possible substrates include transparent substrates, such as glass, and flexible substrates such as papers, thin metal foils, plastic foils, textiles, etc.

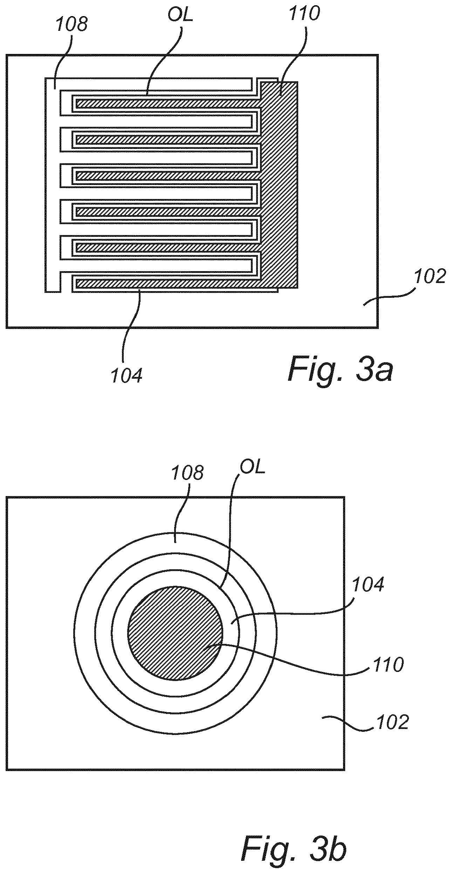

The gate overlapping line may be a straight line in a plane of the second gate layer 104. However, as will be discussed below, the topology of the light-emitting device 100 may be varied in a number of different ways allowing the gate overlapping line to be freely varied. As shown in the top views of an OG-OLET in Figs 3a-b, the gate overlapping line (marked as OL) does not necessarily need to be straight.

In the following top views of an OG-OLET, a layout of some layers in the topology are illustrated although it should be realized that some of these layers may not necessarily be visible in a top view as they may be covered by upper layers (such as the first gate layer 102 being below the first insulating layer 112).

Fig. 3a shows an OG-OLET device with interdigitated fingers. In this embodiment, the second gate layer 104 as well as the first electrode 108 and the second electrode 110 are structured with a finger pattern to define a zigzagging channel, in which the radiative recombination zone of the active layer 106 may be formed. In an alternative embodiment shown in Fig. 3b, an OG-OLET design is provided with a circular channel, whereby a circular radiative recombination zone in the active layer 106 may be defined.

It should be realized that the pattern of the first and second gate layer 102,104 and the first and second electrodes 108, 110 may be varied in numerous other ways. There may be several reasons for forming the topologies indicated in Figs 3a-b or other topologies. For instance, a form factor of the light-emitting device 100 may be decreased to concentrate light output to a small area. Also, the topologies may be designed to rationalize electrostatics of the light-emitting device 100, such as to reduce fringe fields.Also, the use of circular channel as shown in Fig. 3b may be used for forming a circular cavity for stimulated emission of radiation within the active layer 106 so as to provide a laser based on the structure of the light-emitting device.

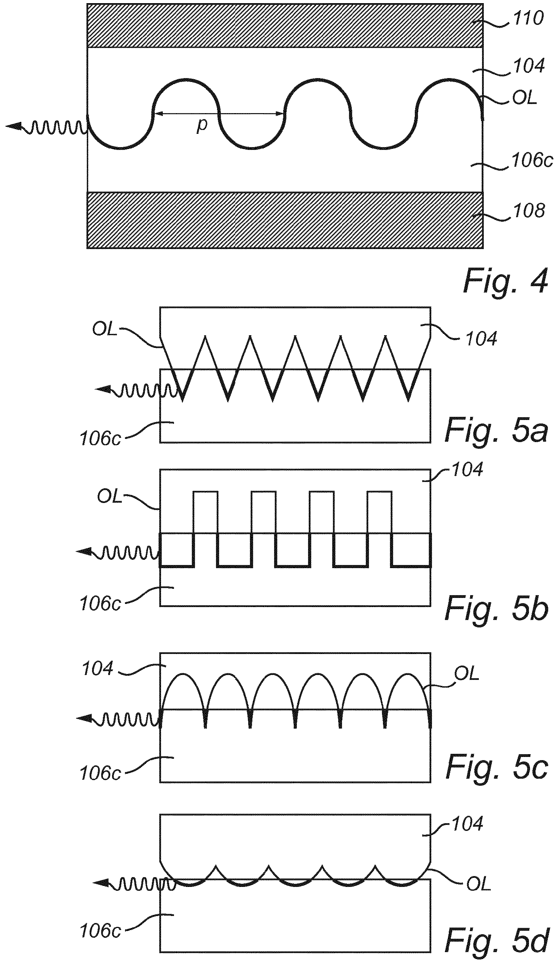

Referring now to Figs 4-6, characteristics of light emission of the light-emitting device 100 may also or alternatively be modified by forming pattern of one or both of the first and second gate layers 102, 104 and/or by forming pattern of one or more of the transport and emissive layers 106a-c of the active layer 106.

In some embodiments, it may be desired that light emission is to spread out to a large area comprised in the transistor channel of the active layer 106. For instance, this may be relevant if there is a need to increase device lifetime.

In some embodiments it may be desired that light emission is localized to small areas comprised in the transistor channel. For instance, this may be relevant to enhance the light emission per unit area, e.g. in order to locally reach a threshold for stimulated emission (lasing threshold). Also by regularly spacing out the areas of light emission, resonant modes for the emitted light may be sustained in the device. To this end, a pitch distance separating arrayed emissive regions may be a multiple of the wavelength of the emitted light.

Localization of the recombination zone can be achieved by engineering a shape of the gate overlapping line OL, which may then affect where the radiative recombination zone will be formed in the active layer 106. The shape of the gate overlapping line OL may be designed to be non-straight in a region between the first electrode 108 and the second electrode 110. The shape of the gate overlapping line OL may be achieved by patterning the shape of the second gate layer 104 in relation to the first gate layer 102. The first gate layer 102 may also be patterned such that the patterns of the first and second gate layers 102, 104 may together form a desired shape of the gate overlapping line OL. Alternatively or additionally, the shape of one or more of the transport and emissive layers 106a-c of the active layer 106 may be patterned to modify the way the layers 106a-c cover the gate overlapping line OL and hence affect the localization of the radiative recombination zone.

Figs 4-6 show examples of patterning to affect localization of the radiative recombination zone. In Fig. 4, the first gate layer 102 is not patterned, and an edge 105 of the second gate layer 104 has a sinusoidal shape with period *p* so that the gate overlapping line OL covers a large portion of a channel in the active layer 106 between the first electrode 108 and the second electrode 110, which are here illustrated to be straight and parallel. In this example, the period *p* can be further reduced in order to increase the length of the gate overlapping line OL relative to the width of the channel. In the topology illustrated in Fig. 4, the radiative recombination zone is more spread out into the channel and larger area emission is obtained. It should be realized that many other shapes of the edge 105 of the second gate layer 104 may be used to modify the gate overlapping line OL.

In Figs 5a-d, embodiments are illustrated for localizing the recombination zone into small areas. In Figs 5a-d, the first gate layer 102 is not patterned, the second gate layer 104 has a saw-tooth shape with teeth of different shapes, defining a gate overlapping line OL of the same shape. The active transport layer, which may be either ETL 106c or HTL 106a, that is gated by the first gate layer 102 may then be patterned to cover only an extremity of tips of the gate overlapping line OL.

In the configurations illustrated in Figs 5a-d, the radiative recombination zone is limited to a section in the active layer 106 above the gate overlapping line OL, where the gate overlapping line OL is covered by the active transport layer gated by the first gate layer 102. Therefore, light emission may be constrained to that section of the active layer 106 resulting in a concentration of light emission.

Figs 5a-d illustrate possible structures for the shape of teeth of a sawtooth shape of the second gate layer 104, such as partially circular, rectangular, sharp-pin, or polygonal shapes. It should be realized that many other shapes may be contemplated and need not necessarily involve the second gate layer 104 even having a sawtooth shape. Also, the shape of the patterned ETL 106c or HTL 106a may also be varied and many other shapes may be contemplated.

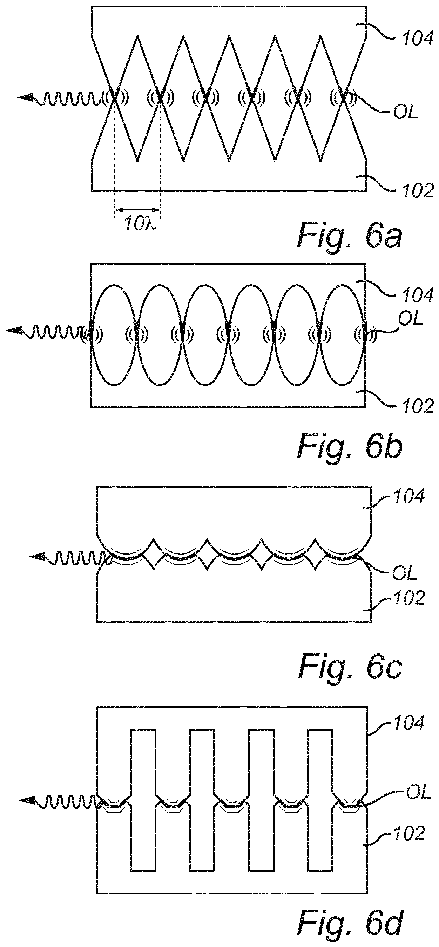

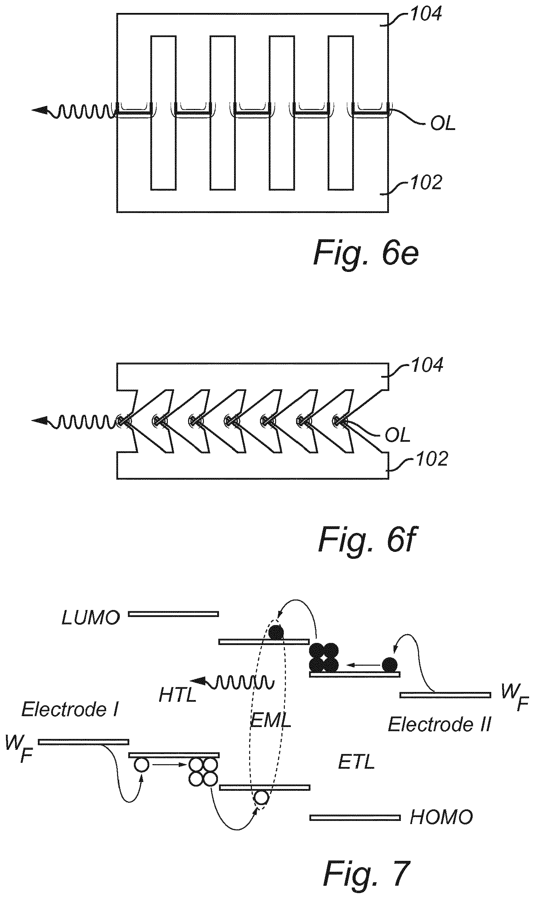

In Figs 6a-f, other embodiments are illustrated for localizing the recombination zone into small areas. In Figs 6a-f, both the first gate layer 102 and the second gate layer 104 are patterned with specific structures having protrusions extending towards each other such that an overlap between the first gate layer 102 and the second gate layer 104 may be formed at ends of the protrusions, whereby a discontinuous gate overlapping line OL may be defined. The pitch, i.e. a distance between successive protrusion, may be chosen to correspond to a multiple of the wavelength of the emitted light, as indicated in Fig. 6a, wherein a pitch of 10 times the wavelength (10λ) is shown. As illustrated in Figs 6a-f, the shapes of the first gate layer 102 and the second gate layer 104 may be saw-tooth, circular, rectangular, sharp-pin, or polygonal shapes so that sharp tips are covering each other, defining a gate overlapping line OL with very small portions. One or more of the transport and emissive layers 106a-c of the active layer 106 may be further patterned to decrease recombination currents as explained above. In this case, current is efficiently channeled to a small recombination area resulting in light concentration in the vicinity of the discontinous gate overlapping line OL.

In the embodiment illustrated in Fig. 6f, the protrusions of the first gate layer 102 have a longitudinal direction which is not parallel to a longitudinal direction of protrusions of the second gate layer 104. This implies that the protrusions need not be very accurately aligned in order to at least form some overlap, as may otherwise be a risk of shapes e.g. as illustrated in Figs 6a-b. Thus, the pattern of the first and second gate layers 102, 104 may be formed without extreme requirements on accuracy of patterning of the gate layers 102, 104 in order to achieve a discontinuous gate overlapping line OL with desired properties.

As discussed above, the active layer 106 may be formed by a plurality of specialized layers, the HTL 106a, the ETL 106c, as well as the EML 106b. Each layer may be specifically adapted to a function associated with the layer and therefore careful consideration regarding materials choice and film forming technique may be practised. Also, an interface formed between adjacent layers within the active layer 106 is relevant and may be considered in decision on material choice. Further, an interface between the second insulating layer 114 and the transport and emissive layers 106a-c of the active layer 106 as well as between metal electrodes 108, 110 and the transport and emissive layers 106a-c of the active layer 106 matters and may need careful interface engineering. In the following, a number of considerations guiding material choices are outlined.

The HTL 106a may be formed of a semiconducting film characterized by a large lateral p-type mobility. Organic semiconductors such as Tetracene derivatives, pentacene derivatives, dinaphtho[2,3-b:2',3'-f]thieno[3,2-b]thiophene (DNTT) derivatives, [1]benzothieno[3,2-b]benzothiophene (BTBT) derivatives, thiophene derivatives, anthradithiophene derivatives, Bis(ethylenedithio)tetrathiafulvalene, Anthra[2,3-b:6,7-b']dithiophene, 2,4-Bis[4-(N,N-dibenzylamino)-2,6-dihydroxyphenyl]squaraine, 2-[(7-{4-[N,N-Bis(4-methylphenyl)amino]phenyl}-2,1,3-benzothiadiazol-4-yl)methylene]propanedinitrile (DTDCPB), Metal Phthalocyanine derivatives, Coronene derivatives, 5,5'-Bis(7-hexyl-9H-fluoren-2-yl)-2,2'-bithiophene (DH-FTTF), Dibenzotetrathiafulvalene, 2-((7-(4-(Diphenylamino)phenyl)benzo[c][1,2,5]thiadiazol-4-yl)methylene)malononitrile (DPDCPB), 2-[[7-[5-[Bis(4-methylphenyl)amino]-2-thienyl]-2,1,3-benzothiadiazol-4-yl]methylene]propanedinitrile (DTDCTB), 7,7'-[4,4-Bis(2-ethylhexyl)-4H-silolo[3,2-b:4,5-b']dithiophene-2,6-diyl]bis[6-fluoro-4-(5'-hexyl-[2,2'-bithiophen]-5-yl)benzo[c][1,2,5]thiadiazole] [DTS(FBTTh₂)₂], 4,4'-[4,4-Bis(2-ethylhexyl)-4H-silolo[3,2-b:4,5-b']dithiophene-2,6-diyl]bis[7-(5'-hexyl-[2,2'-bithiophen]-5-yl)-[1,2,5]thiadiazolo[3,4-c]pyridine] [DTS(PTTh₂)₂], 5,5'-Di(9H-fluoren-2-yl)-2,2'-bithiophene (FTTF), Diketopyrrolopyrrolethienothiophene copolymer (PDPP2T-TT-OD), 2,5-Di-(2-ethylhexyl)-3,6-bis-(5"-n-hexyl-[2,2',5',2"]terthiophen-5-yl)-pyrrolo[3,4-c]pyrrole-1,4-dione (SMDPPEH), 2,5-Dioctyl-3,6-bis-(5"-n-hexyl-[2,2',5',2']terthiophen-5-yl)-pyrrolo[3,4-c]pyrrole-1,4-dione (SMDPPO), 5,11-Bis(triethylsilylethynyl)anthradithiophene (TES-ADT), Tris[4-(5-dicyanomethylidenemethyl-2-thienyl)phenyl]amine (TDCV-TPA), Poly(9,9-dioctylfluorene-alt-benzothiadiazole) (F8BT), Poly(9,9-dioctylfluorene-altbithiophene) (F8T2), Poly(p-phenylene vinylene) derivatives, Poly[(5,6-dihydro-5-octyl-4,6-dioxo-4H-thieno[3,4-C]pyrrole-1,3-diyl){4,8-bis[(2-butyloctyl)oxy]benzo[1,2-b:4,5-b']dithiophene-2,6-diyl}] (PBDTBO-TPDO), Poly[(5,6-dihydro-5-octyl-4,6-dioxo-4H-thieno[3,4-c]pyrrole-1,3-diyl)[4,8-bis[(2-ethylhexyl)oxy]benzo[1,2-b:4,5-b1dithiophene-2,6-diyl]] [PBDT(EH)-TPD(Oct)], Poly[[5-(2-ethylhexyl)-5,6-dihydro-4,6-dioxo-4H-thieno[3,4-c]pyrrole-1,3-diyl][4,8-bis[(2-ethylhexyl)oxy]benzo[1,2-b:4,5-b']dithiophene-2,6-diyl]] (PBDT-TPD), Poly[1-(6-{4,8-bis[(2-ethylhexyl)oxy]-6-methyl benzo[1,2-b:4,5-b']d ith iophen-2-yl}-3-fl uoro-4-methylth ieno[3,4-b]thiophen-2-yl)-1-octanone] (PBDTTT-CF), Poly[[5-(2-ethylhexyl)-5,6-dihydro-4,6-dioxo-4H-thieno[3,4-c]pyrrole-1,3-diyl](4,4'-didodecyl[2,2'-bithiophene]-5,5'-diyl)] (PBTTPD), Poly[2,5-bis(3-tetradecylthiophen-2-yl)thieno[3,2-b]thiophene] (PBTTT-C14), Poly[N-9'-heptadecanyl-2,7-carbazole-alt-5,5-(4',7'-di-2-thienyl-2',1',3'-benzothiadiazole)] (PCDTBT), Poly[2,6-(4,4-bis-(2-ethylhexyl)-4H-cyclopenta [2,1-b;3,4-b']dithiophene)-alt-4,7(2,1,3-benzothiadiazole)] (PCPDTBT), Poly[(5,6-dihydro-5-octyl-4,6-dioxo-4H-thieno[3,4-c]pyrrole-1,3-diyl)[4,4-bis(2-ethylhexyl)-4H-silolo[3,2-b:4,5-b';]dithiophene-2,6-diyl]] (PDTSTPD), Poly[2,7-(9,9-dioctylfluorene)-alt-4,7-bis(thiophen-2-yl)benzo-2,1,3-thiadiazole] (PFO-DBT), Poly({4,8-bis[(2-ethylhexyl)oxy]benzo[1,2-b:4,5-b']dithiophene-2,6-diyl}{3-fluoro-2-[(2-ethylhexyl)carbonyl]thieno[3,4-b]thiophenediyl}) (PTB7), Poly(3-dodecylthiophene-2,5-diyl) (P3DDT), Poly[2,7-(9,9-dioctyl-dibenzosilole)-alt-4,7-bis(thiophen-2-yl)benzo-2,1,3-thiadiazole] (PSiF-DBT), Poly[bis(4-phenyl)(2,4,6-trimethylphenyl)amine] (PTAA), Poly[[2,3-bis(3-octyloxyphenyl)-5,8-quinoxalinediyl]-2,5-thiophenediyl] (TQ1), Poly(2,3-dihydrothieno-1,4-dioxin)-poly(styrenesulfonate) (PEDOT:PSS), 1,4,5,8,9,11-Hexaazatriphenylenehexacarbonitrile (HAT-CN), Tris(4-carbazoyl-9-ylphenyl)amine (TCTA), 4,4'-Cyclohexylidenebis[N,N-bis(4-methylphenyl)benzenamine] (TAPC), 1,3-Bis(N-carbazolyl)benzene (mcp), N,N'-Di(1-naphthyl)-N,N'-diphenyl-(1,1'-biphenyl)-4,4'-diamine (NPB), N,N,N',N'-Tetrakis(4-methoxyphenyl)benzidine (MeO-TPD), 4,4'-(Diphenylsilanediyl)bis(N,N-diphenylaniline) (TSBPA), N,N'-di-phenyl-N,N'-di-[4-(N,N-di-phenyl-amino)pheny]benzidine (NPNPB), etc may be used by depositing thin films using vapor or liquid phase techniques.. However, the material used in the HTL 106a is not limited to these examples. Perovskite and organohalide perovskites materials, p-type metal oxides such as SnO and CuO, graphene, carbon nanotube can also be grown either through vapor or liquid phases and form a thin film displaying a suitable p-type mobility exceeding 1 cm²/Vs.

An interface between the HTL 106a and an underlying layer may advantageously allow for high charge accumulation and lateral transport while limiting charge trapping event. When the HTL 106a is applied on the second insulating layer 114, a suitable surface treatment based on a self-assembled monolayer of phosphonic acids or silanes could be used, which may provide a favorable growth and a reduction of electrical defects. When the HTL 106a is applied above the EML 106b, a suitable barrier between the highest occupied molecular orbital (HOMO) or valence band of the HTL 106a and the HOMO or valence band of the EML 106b may allow for charge accumulation as depicted in Fig. 7. This barrier, however, should not be too large such that the barrier does not hamper charge injection in the EML 106b at the radiative recombination zone.

A material choice for the second electrode 110 that injects holes into the HTL 106a may be guided by a desire to reduce contact resistance as much as possible. This may guide a careful selection of the metal and the use of contact doping layers and methodologies. Doping can be achieved through a thin MoOx, ReOx, WOx, FeCl₃, V₂O₅, SbCl₅ or Cul film sandwiched between the HTL 106a and the metal electrode 110. Organic dopants such as 2,3,5,6-Tetrafluoro-7,7,8,8-tetracyanoquinodimethane (F4-TCNQ), 2,2'-(perfluoronaphthalene-2,6-diylidene)dimalononitrile (F6-TCNNQ), C₆₀F₃₆, Poly(3,4-ethylenedioxythiophene)-poly(styrenesulfonate) (PEDOT:PSS), 7,7,8,8-Tetracyanoquinodimethane (TCNQ), molybdenum tris(1-(methoxycarbonyl)-2-(trifluoromethyl)ethane-1,2-dithiolene) [Mo(tfd-CO₂Me)₃] , molybdenum tris(1,2-bis(trifluoromethyl)ethane-1,2-dithiolene [Mo(tfd)₃], molybdenum tris(1-(trifluoroacetyl)-2-(trifluoromethyl)ethane-1,2-dithiolene) [Mo(tfd-COCF₃)₃], or 1,4,5,8,9,11-Hexaazatriphenylenehexacarbonitrile (HAT-CN) are also good candidates for contact optimization. However, the material used in the injecting layer is not limited to the examples.

The ETL 106c may be formed of a semiconducting film characterized by a large lateral n-type mobility. Ideally, this mobility should match that of the HTL 106a mentioned above. High mobility n-type organic semiconductors exist: fullerenes (C₆₀) derivatives, N,N'-dimethyl-3,4,9,10-perylene dicarboximide derivatives, Perylene-3,4,9,10-tetracarboxylic dianhydride derivatives, Naphthalene derivatives, TCNQ derivatives, Perylene derivatives, [6,6]-Phenyl C61 butyric acid methyl ester (PCBM) derivatives, phthalocyanine derivatives, Naphthalenetetracarboxylic dianhydride derivatives, Poly(2,5-di(3,7-dimethyloctyloxy)cyanoterephthalylidene), Poly(2,5-di(hexyloxy)cyanoterephthalylidene), Thiazole-thiophene oligomers, thiophene derivatives, diperfluorohexylcarbonyl (DFHCO) derivatives, Bathophenanthroline (Bphen), Bis(8-hydroxy-2-methylquinoline)-(4-phenylphenoxy)aluminum (Balq), 2,7-Di(2,2'-bipyridin-5-yl)triphenylene (BPy-TP2), 2,2'-(4,4'-(Phenylphosphoryl)bis(4,1-phenylene))bis(1-phenyl-1H - benzo[d]imidazole) (BIPO), Diphenylbis(4-(pyridin-3-yl)phenyl)silane (DPPS), 4,7-Diphenyl-2,9-bis(4-(1-phenyl-1H -benzo[d ]imidazol-2-yl)phenyl)-1,10-phenanthroline (DBimiBphen), 2,2',2"-(1,3,5-Benzinetriyl)-tris(1-phenyl-1-H-benzimidazole) (TPBi), 2,4,6-Tris[3-(diphenylphosphinyl)phenyl]-1,3,5-triazine (PO-T2T), 4,6-Bis(3,5-di-3-pyridylphenyl)-2-methylpyrimidine (B3PYMPM), 4,6-Bis(3,5-di(pyridin-2-yl)phenyl)-2-methylpyrimidine (B2PYMPM), 4,6-Bis(3,5-di(pyridin-4-yl)phenyl)-2-methylpyrimidine (B4PYMPM), 4,6-Bis(3,5-di(pyridin-3-yl)phenyl)-2-(pyridin-3-yl)pyrimidine (B3PYPPM), 1,3,5-Tri(m-pyridin-3-ylphenyl)benzene (TmPyPb), 2,4,6-Tris(3'-(pyridin-3-yl)biphenyl-3-yl)-1,3,5-triazine (TmPPPyTz), 1,3,5-Tri(diphenylphosphoryl-phen-3-yl) benzene (TP3PO), 3,5-Di(pyren-1-yl)pyridine (PY1), PmPyPb, Tris(8-hydroxyquinolinato)aluminium (Alq₃), Bathocuproine (BCP), 8-Hydroxyquinolinolato-lithium (Liq), or Bis(10-hydroxybenzo[h]quinolinato)beryllium (Bepq₂) that can be processed in thin films through vapor or liquid phase techniques. Alternative n-type semiconductors are inorganic metal oxides such as ZnO, ZTO, IZO, IGZO, TiOx or ZnON, and graphene or carbon nanotubes. Thin films of these can be grown either through vapor phase techniques (sputtering) or liquid processing (nanoparticle dispersion coating, sol-gel processing, etc.). However, the material used in the ETL 106c is not limited to the examples.

The inorganic materials exemplified above present an advantage of a better processability and less sensitivity to environmental damage. Also, these materials usually present a high refractive index relative to an organic semiconductor, which can be useful for optical engineering of the OG-OLET device, as detailed below in forming of a laser based on the OG-OLET structure.

An interface formed between the ETL 106c and an underlying layer may advantageously allow for high charge accumulation and lateral transport while limiting charge trapping event. This may be achieved through careful interface engineering through suitable pretreatment such as with a self-assembled monolayer of phosphonic acids or silanes or with a highly polar interlayer such as polyethylenimine ethoxylated (PEIE) interlayer. The pretreament could provide interfacial improvements such as a favorable growth, a reduction of electrical defects and band energy adjustment to facilitate charge injection or extraction. When the ETL 106c is applied above the EML 106b, a suitable barrier between the lowest unoccupied molecular orbital (LUMO) or conduction band of the ETL 106c and the LUMO or conduction band of the EML 106b may allow for charge accumulation as depicted in Fig. 7. This barrier, however, should not be too large such that the barrier does not hamper charge injection in the EML 106b at the radiative recombination zone.

A material choice for the first electrode 108 that injects electrons into the ETL 106c may be guided by a desire to reduce contact resistance as much as possible. This may guide a careful selection of the metal and the use of contact doping layers and methodologies based, for example, on a thin Li, LiF, Ca, Yb, Mg, Cs, Rb, CsF, Cs₂CO₃, Rb₂CO₃, CsN₃ film sandwiched between the ETL 106c and the metal electrode 108. Organic dopants such as pyronin B chloride, 8-Hydroxyquinolinolato-lithium (Liq), 2-(2-Methoxyphenyl)-1,3-dimethyl-1H-benzoimidazol-3-ium iodide (o-MeO-DMBI), Bis(pentamethylcyclopentadienyl)cobalt(II) (CoCp₂), Pentamethylcyclopentadienyl cyclopentadienyl rhodium dimer, Mesitylene pentamethylcyclopentadienyl ruthenium dimer, or 1,3-Dimethyl-2-phenyl-2,3-dihydro-1H-benzoimidazole (DMBI), are also good candidates for contact optimization. However, the material used in the injecting layer is not limited to the examples.

The EML 106b may be designed taking a number of constraints into account. The EML 106b should allow for efficient charge injection from the HTL 106a and the ETL 106c into the recombination zone. Exciton formation should be rapid and their radiative decay should be favored over all other possible pathways that quench photoluminiscence. To this end, the EML 106b can be formed of a pure material such as Alq₃, F8BT, Anthracene derivatives, Tetracene derivatives, Pentacene derivatives, 4,4'-Bis(N-carbazolyl)-1,1'-biphenyl (CBP) derivatives, N,N' -Di-(1-naphthalenyl)-N,N' - diphenyl-[1,1':4',1":4",1‴-quaterphenyl]-4,4‴-diamine (4P-NPB), BeBq₂, mcp, 3,3-di(9H-carbazol-9-yl)biphenyl (mCBP), 1,3,5-Tris(carbazol-9-yl)benzene (TCP), Bis(triphenylsilyl)benzene derivatives, 3,3'-(9H,9'H-3,4'-bicarbazole-9,9'-diyl)dibenzonitrile (3CN34BCz), Bis(triphenylsilyl) derivatives, MPMP, 9-(4-tert -butylphenyl)-3,6-bis(triphenylsilyl)-9H-carbazole (CzSi), CzC, DFC, 1,1'-(2,5-Dimethyl-1,4-phenylene)dipyrene (DMPPP), 2,6-Bis(3-(9H -carbazol-9-yl)phenyl)pyridine (26DCzPPy), 9,9-Dimethyl-N,N -diphenyl-7-(4-(1-phenyl-1H-benzo[d ]imidazol-2-yl)phenyl)-9H -fluoren-2-amine (EFIN), 3,5-Bis(3-(9H -carbazol-9-yl)phenyl)pyridine (35DCzPPy), 9,9-Spirobifluoren-2-yl-diphenylphosphine oxide (SPPO1), 9,9'-(5-(Triphenylsilyl)-1,3-phenylene)bis(9H - carbazole) (Simcp), 4,4,8,8,-12,12-Hexa-p -tolyl-4H -8H -12H -12C - azadibenzo[cd,mn ]pyrene (FATPA), 4,7-Di(9H -carbazol-9-yl)-1,10-phenanthroline (BUPH1), BCBP, PPT, Bis(3,5-di(9H-carbazol-9-yl)phenyl)diphenylsilane (SimCP2), 9,9',9",9‴,9ʺʺ,9‴ʺ-((phenylsilanetriyl)tris(benzene-5,3,1-triyl))hexakis(9H-carbazole) (SimCP3), 3,6-di(9-carbazolyl)-9-(2-ethylhexyl) (TCz1), 3-(Diphenylphosphoryl)-9-(4-(diphenylphosphoryl)phenyl)-9H -carbazole (PPO21), 3,6-Bis[(3,5-diphenyl)phenyl]-9-phenyl-carbazole (CzTP), Dibenzo{[f,f' ]-4,4',7,7'-tetraphenyl}diindeno[1,2,3-cd :1',2',3'-lm ]perylene (DBP), 2,8-Di(9H-carbazol-9-yl)dibenzo[b,d]thiophene (DCzDBT), 4,4'-Bis(2,2-diphenylethenyl)-1,1'-biphenyl (DPVBi), 10-(4'-(Diphenylamino)biphenyl-4-yl)acridin-9(10H )-one (ADBP), 2,7-Bis(diphenylphosphoryl)-9,9'-spirobifluorene (SPPO13), 1,4-Bis((9H-carbazol-9-yl)methyl)benzene (DCB), Bis-4-(N-carbazolyl)phenyl)phenylphosphine oxide (BCPO), 9,9-Bis[4-(pyrenyl)phenyl]-9H -fluorene (BPPF), POAPF, 2,7-Bis(diphenylphosphoryl)-9-phenyl-9H - carbazole (PPO27), Poly[(9,9-bis(3'-(N,N -dimethylamino)propyl)-2,7-fluorene)-alt-2,7-(9,9-dioctylfluorene)] (PFN-DOF), 2,7-Bis(diphenylphosphoryl)spiro[fluorene-7,11'-benzofluorene] (SPPO21), Di(9,9-spirobifluoren-2-yl)-phenyl-phosphine oxide (Dspiro-PO), 4" ,4‴-(Phenylphosphoryl)bis(N-1-naphthyl-N-phenyl-1,1':4',1"-terphenyl-4-amine) (NP3PPO), 4‴ ,4""-(Phenylphosphoryl)bis(N -1-naphthyl-N -phenyl-1,1':4',1":4",1‴-quaterphenyl-4-amine) (NP4PPO), Poly[3-(carbazol-9-ylmethyl)-3-methyloxetane] (PCMO), Poly[3-(carbazol-9-yl)-9-(3-methyloxetan-3-ylmethyl)carbazole] (PCOC), 9-(3,5-Bis(diphenylphosphoryl)phenyl)-9H -carbazole (CzPO2), 3,5-Di(9H -carbazol-9-yl)biphenyl (Ph-MCP), 9-Phenyl-3,6-bis(4-(1-phenyl-1H -benzo[d ]imidazol-2-yl)phenyl)-9H -carbazole (CNBzlm), 9-(3-(9H -Carbazol-9-yl)phenyl)-3-(diphenylphosphoryl)-9H -carbazole (mCPPO1), Diphenyl-4-triphenylsilylphenyl-phosphine oxide (TSPO1), 1,3,5-Tri(pyren-1-yl)benzene (TPB3), Bis(9,9-spirobifluorene-3-yl)-phenylphosphane oxide (SF3PO), 9,9-Spirobifluoren-4-yl-diphenyl-phosphineoxide (SPPO11), 9-(8-(Diphenylphosphoryl)dibenzo[b,d ]furan-2-yl)-9H-carbazole (DFCzPO), Dibenzofuran-4-yl-diphenyl-phosphine-oxide (DBFPPO), 9,9-Di(9-methyl-carbazol-3-yl)-4,5-diazafluoren (MCAF), 3-(3-(9H-Carbazol-9-yl)phenyl)benzofuro[2,3-b ]pyridine (PCz-BFP), Poly(9-vinylcarbazole) derivatives, 9-(4-(9H-pyrido[2,3-b]indol-9-yl)phenyl)-9H-3,9'-bicarbazole (pBCb2Cz), 4,4'-bisBis(2,2-diphenyl-ethene-1-yl)-4,4'-dimethylphenyl (p-DMDPVBi), 2,7-Bis[9,9-di(4-methylphenyl)-fluoren-2-yl]-9,9-di(4-methylphenyl)fluorene (TDAF), Tris[4-(pyrenyl)-phenyl]amine (TPyPA), 2-(9,9-Spirobifluoren-2-yl)-9,9-spirobifluorene (BSBF), 2-[9,9-Di(4-methylphenyl)-fluoren-2-yl]-9,9-di(4-methylphenyl)fluorene (BDAF), 2,7-Bis(9,9-spirobifluoren-2-yl)-9,9-spirobifluorene (TSBF), 2,7-Dipyrenyl-9,9-spirobifluorene (Spiro-Pye), 2,2'-Dipyrenyl-9,9-spirobifluorene (2,2'-Spiro-Pye), with ambipolar character and high fluorescent yield.

Alternatively, the EML could be made of a complex host-guest system, for example, Alq₃ doped with emissive 4-(Dicyanomethylene)-2-tert-butyl-6-(1,1,7,7-tetramethyljulolidin-4-yl-vinyl)-4H-pyran (DCJTB). In this case, the guest molecule has higher fluorescent yield than the host molecule and the high fluorescent yield can be achived by diluting the guest dopant in the host matrix which reduces an aggregation quenching between the guest molecules. The guest molecules are the emissive centers on which excitons are formed and radiatively decay. Radiative decay may be obtained by fluorescence, phosphorescence, delayed fluorescence or excimer emission. Examples of fluorescent guest molecules may include a fused-ring aromatic compound such as rubrene, coumarin such as 5,12-Dihydro-5,12-dimethylquino[2,3-b]acridine-7,14-dione (DMQA) or 2,3,6,7-Tetrahydro-1,1,7,7,-tetramethyl-1H ,5H ,11H -10-(2-benzothiazolyl)quinolizino[9,9a ,1gh ]coumarin (C545T), or di-pyran such as DCJTB or 4-(Dicyanomethylene)-2-methyl-6-(4-dimethylaminostyryl)-4H-pyran (DCM), 4,4'-Bis(9-ethyl-3-carbazovinylene)-1,1'-biphenyl (BCzVBi), 1,4-Bis[2-(3-N-ethylcarbazoryl)vinyl]benzene (BCzVB), but is not limited thereto. Examples of phosphorescent guest molecules may include Iridium (III) derivatives such as Bis(1,2-diphenyl-1H -benzo[d]imidazole)(acetylacetonate) iridium(III), bis(2-(3,5-dimethylphenyl)-4-(trifluoromethyl)pyridine) Ir(III) (2,2,6,6-tetramethylheptane-3,5-diketonate), Bis(2-(3,5-dimethylphenyl)-4-methylpyridine) Ir(III) (2,2,6,6-tetramethylheptane-3,5-diketonate), Bis(2-(3,5-dimethylphenyl)-4-phenylpyridine) Ir(III) (2,2,6,6-tetramethylheptane-3,5-diketonate), Bis(2-(3,5-dimethylphenyl)-4-propylpyridine) Ir(III) (2,2,6,6-tetramethylheptane-3,5-diketonate), Bis(2-(9,9-diethyl-fluoren-2-yl)-1-phenyl-1H-benzo[d ]imidazolato)(actylacetonate)iridium(III), Bis(2-(naphthalen-2-yl)pyridine)(acetylacetonate)iridium(III), Bis(2,4-difluorophenylpyridinato)(5-(pyridin-2-yl)-1H-tetrazolate) iridium(III), Bis(2,4-difluorophenylpyridinato)tetrakis(1-pyrazolyl)borate iridium(III), Bis(2-benzo[b ]thiophen-2-yl-pyridine)(acetylacetonate)iridium(III), Bis(2-methyldibenzo[f,h ]quinoxaline)(acetylacetonate)iridium(III), Bis(2-phenylbenzothiazolato)(acetylacetonate)iridium(III), Bis(2-phenylpyridine)(3-(pyridin-2-yl)-2H -chromen-2-onate)iridium(III), Bis(2-phenylpyridine)(acetylacetonate)iridium(III), Bis(2-phenylpyridine)iridium(III)(2,2,6,6-tetramethylheptane-3,5-diketonate), Bis(2-phenylquinoline)(2-(3-methylphenyl)pyridinate)iridium(III), Bis(2-phenylquinoline)(2,2,6,6-tetramethylheptane-3,5-dionate)iridium(III), Bis(3,4,5-trifluoro-2-(2-pyridyl)phenyl-(2-carboxypyridyl)iridium(III), Bis(3,5-difluoro-2-(2-pyridyl)phenyl-(2-carboxypyridyl)iridium(III), Bis(3,5-difluoro-4-cyano-2-(2-pyridyl)phenyl-(2-carboxypyridyl) iridium(III), Bis(phenylisoquinoline)(2,2,6,6-tetramethylheptane-3,5-dionate) iridium(III), Bis[(4-n -hexylphenyl)isoquinoline](acetylacetonate)iridium (III), Bis[1-(9,9-dimethyl-9H -fluoren-2-yl)-isoquinoline](acetylacetonate)iridium(III), Bis[2-(2-methylphenyl)-7-methyl-quinoline](acetylacetonate)iridium(III), Bis[2-(3,5-dimethylphenyl)-4-methyl-quinoline](2,2,6,6-tetramethylheptane-3,5-dionate)iridium(III), Bis[2-(3,5-dimethylphenyl)-4-methylquinoline](acetylacetonate)iridium(III), Bis[2-(4-n - hexylphenyl)quinoline](acetylacetonate)iridium(III), Bis[2-(9,9-dimethyl-9H - fluoren-2-yl)quinoline](acetylacetonate)iridium(III), Bis[4-tert -butyl-2',6'-difluoro-2,3'-bipyridine](acetylacetonate)iridium(III), fac-lridium(lll) tris(1-phenyl-3-methylbenzimidazolin-2-ylidene-C,C2'), fac-Tris(1,3-diphenyl-benzimidazolin-2-ylidene-C,C2')iridium(III), fac-Tris(2-phenylpyridine)iridium(III), *fac*-Tris[(2,6-diisopropylphenyl)-2-phenyl-1H - imidazo[e ]]iridium(III), Iridium(III) bis(2-(2,4-difluorophenyl)quinoline) picolinate, Iridium(III) bis(4-(4-tert-butylphenyl) thieno[3,2-c]pyridinato-N,C2') acetylacetonate, *mer*-iridium(III) tris(1-phenyl-3-methylbenzimidazolin-2-ylidene-C,C2'), mer-Tris(1-phenyl-3-methylimidazolin-2-ylidene-C,C(2)'iridium(III), Tris(2-(3-methylphenyl)-7-methyl-quinolato)iridium, Tris(2-(4,6-difuorophenyl)pyridine)iridium(III), Tris(2-phenyl-3-methylpyridine)iridium, Tris[2-(4-n -hexylphenyl)quinoline)]iridium(III), Tris[2-(4-n - hexylphenyl)quinoline)]iridium(III), Tris[2-(p -tolyl)pyridine]iridium(lll), Tris[2-phenyl-4-methylquinoline)]iridium(III), Tris[3-(2,6-dimethylphenoxy)-6-phenylpyridazine]iridium(III), and Platinum (II) derivatives such as Platinum octaethylporphyrin, Pt(II) (3-(trifl uoromethyl)-5-(2-pyridyl)pyrazolate)(picolinate), Pt(II) (5,5'-di(trifl uoromethyl)-3,3'-bipyrazolate)(2,2'-bipyridine), Pt(II) bis(3-(trifl uoromethyl)-5-(2-pyridyl)-pyrazolate), but is not limited thereto. Examples of dopant molecules for thermally activated delayed fluorescence may include 2,8-Di-tert -butyl-5,11-bis(4-tert -butylphenyl)-6,12-diphenyltetracene (TBRb), (4s,6s)-2,4,5,6-tetra(9H-carbazol-9-yl)isophthalonitrile (4CzIPN), 1,3,5-Tris(4-(diphenylamino)phenyl)-2,4,6-tricyanobenzene (3DPA3CN), 1,4-Bis(9,9-dimethylacridan-10-yl-pphenyl)-2,5-bis(ptolyl-methanoyl)benzene (AcPmBPX), 1,4-Bis(9,9-phenoxazin-10-yl-p-phenyl)-2,5-bis(p - tolylmethanoyl)-benzene (PxPmBPX), 10-(4-(4,6-diphenyl-1,3,5-triazin-2-yl)phenyl)-9,9-dimethyl-9,10-dihydroacridine (DMAC-TRZ), 10-(4,6-Diphenyl-1,3,5-triazin-2-yl)-10H -phenoxazine (Phen-TRZ), 10,10'-(4,4'-(4-phenyl-4H - 1,2,4-triazole-3,5-diyl)bis(4,1-phenylene))bis(10H -phenoxazine) (2PXZ-TAZ), 10,10'-(4,4'-sulfonylbis(4,1-phenylene))bis(10H -phenoxazine) (PXZ-DPS), 10,10'-(4,4'-sulfonylbis(4,1-phenylene))bis(9,9-dimethyl-9,10-dihydroacridine) (DMAC-DPS), 10-Phenyl-10H ,10'H -spiro[acridine-9,9'-anthracen]-10'-one (ACRSA), 2- (9- phenyl- 9H-carbazol-3-yl)-10,10- dioxide-9H-thioxanthen-9-one (TXO-PhCz), 2- [4- (diphenylamino) phenyl] - 10, 10- dioxide-9H - thioxanthen-9- one (TXO-TPA), 2,4,6-Tris[3-(diphenylphosphinyl)phenyl]-1,3,5-triazine (CPC), 2,5,8,11-Tetra-tert -butylperylene (TBPe), 2,5-bis(4-(10H-phenoxazin-10-yl)phenyl)-1,3,4-oxadiazole (2PXZ-OXD), 2,7-Bis(diphenylamino)-10-phenyl-10H -spiro(acridine-9,9'(4,5-diazafluorene) (DPAA-AF), 3-(9,9-dimethylacridin-10(9H )-yl)-9H -xanthen-9-one (ACRXTN), 3,6-Dibenzoyl-4,5-Di(1-methyl-9-phenyl-9H-carbazoyl)-2-ethynylbenzonitrile (Cz-VPN), 4,4"-Di-10H-phenoxazin-10-yl[1,1':2',1"-terphenyl]-4',5'-dicarbonitrile (Px-VPN), 4,5-di (9H-carbazol-9-yl) phthalonitrile (2CzPN), 5,10-Bis(4-(1-phenyl-1H -benzo[d]imidazol-2-yl)phenyl)-5,10-dihydrophenazine (DHPZ-2BI), 9'- [4- (4, 6- diphenyl- 1,3,5- triazin- 2-yl) phenyl]-3,3", 6,6"-tetraphenyl-9,3 ':6',9"-ter-9H-carbazole (BDPCC-TPTA), 9'- [4- (4, 6-diphenyl-1, 3, 5-triazin-2-yl) phenyl] -9, 3':6', 9"-ter- 9H-carbazole (BCC-TPTA), 9-(4-(4,6-Diphenyl-1,3,5-triazin-2-yl)phenyl)-3',6'- diphenyl-9H -3,9'-bicarbazole (DPCC-TPTA), 9-(4-(4,6-Diphenyl-1,3,5-triazin-2-yl)phenyl)-9H -carbazole (Cab-Ph-TRZ), 9,10-Bis[N,N -di-(p -tolyl)-amino]anthracene (TTPA), 9,9'-(4,4'-sulfonylbis(4,1-phenylene))bis(3,6-dimethoxy-9H -carbazole) (DMOC-DPS), 9,9'-(4,4'-sulfonylbis(4,1-phenylene))bis(3,6-di-tert -butyl-9H -carbazole) (CZ-PS), 9,9'-(5-(4,6-diphenyl-1,3,5-triazin-2-yl)-1,3-phenylene)bis(9H -carbazole) (DCzTrz), 9,9',9"-(5-(4,6-diphenyl-1,3,5-triazin-2-yl)benzene-1,2,3-triyl) tris(3,6-dimethyl-9H-carbazole) (TmCzTrz), 9,9',9"-(5-(4,6-diphenyl-1,3,5-triazin-2-yl)benzene-1,2,3-triyl) tris(9H-carbazole) (TCzTrz), 9,9',9",9‴-((6-phenyl-1,3,5-triazine-2,4-diyl)bis(benzene-5,3,1-triyl))tetrakis(9H -carbazole) (DDCzTrz), Bis(4-(9H -3,9'-bicarbazol-9-yl)phenyl)methanone (CC2BP), Dibenzo{[f,f]-4,4',7,7'-tetraphenyl}diindeno[1,2,3-cd :1',2',3'-lm ]perylene (DBP), but is not limited thereto. Inorganic emissive layers such as films based on quantum dots or organohalide perovskites emitters can also be used in OG-OLETs.

The host-guest system emissive layer may be sandwiched between thin interlayers of a pure host material. This would isolate the transport layers from the emissive host-guest system and thereby reduce trapping and quenching of charge carriers by the guest molecules. Therefore, the host-guest system optimized for light emission does not hamper charge injection and charge transport to the emissive centers. It should also be realized that a thin interlayer of a pure host material may be arranged only on one side of the EML 106b.

In order for the light-emitting device 100 to output as much light as possible of the generated light in the EML 106b, it may be important to reduce self-reabsorption by the EML 106b or reabsorption by the transport layers 106a, 106c. In this regard, negligible spectrum overlap between emission spectrum of EML 106b and absorption spectrum of the transporting layers 106a, 106c may be beneficial. Therefore, wide band gap materials with low absorption within the spectrum range to be output, such as the visible spectrum, are preferred.

The transition dipole orientation may also be taken into account in order to increase output of light, depending on the desired application. Emissive materials with a transition dipole orientation mostly parallel to the substrate 101 is good for output of light perpendicular to the substrate 101. Similarly, emissive materials having a transition dipole orientation mostly orthogonal to the substrate 101 is good for output of light from an edge of the substrate 101.

As discussed below, the refractive indexes as well as thicknesses of the transport layers 106a, 106c and the emissive layer 106b of the active layer 106 and of the second insulating layer 114 may also influence propagation of light in the layers and output of light from the device 100.

The OG-OLET topology discussed above offers many routes towards complex optoelectronic device fabrication, which may be used for different purposes of the device.

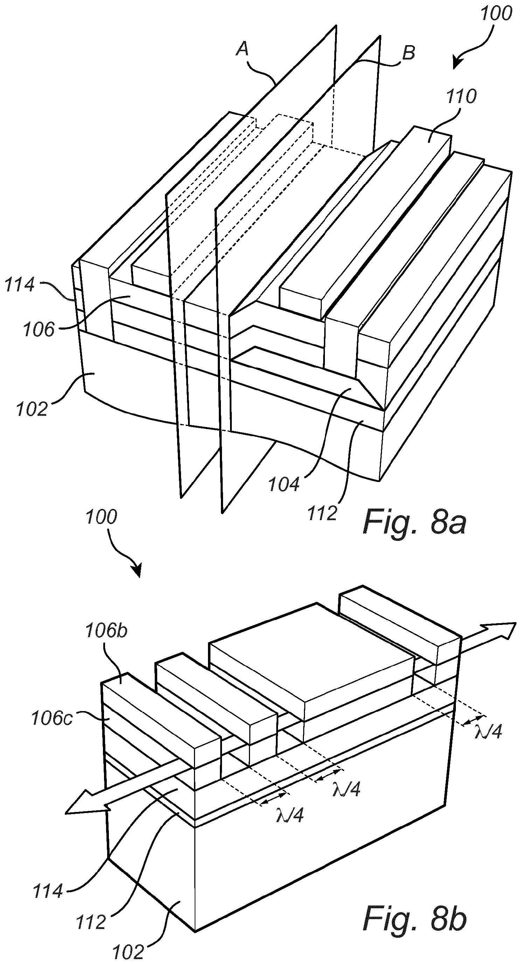

Referring now to Figs 8a-b, a particular use of the light-emitting device 100 will be discussed, namely to form a laser based on the structure of the light-emitting device 100. An electrically pumped organic laser may need a device layout that combines excellent characteristics for current driving, light emission, positive feedback in an optical cavity and light outcoupling. Through its flexibility, the OG-OLET topology permits to integrate all these functions into a single device.

The positive feedback may be provided by means of a resonating structure that redirects light output from the radiative recombination zone back into the radiative recombination zone. Such resonating structures may be arranged on opposite sides of the radiative recombination zone in order to form an optical cavity in the radiative recombination zone.

Since charge carriers are to be transported from the electrodes 108, 110 into the radiative recombination zone, the resonating sturctures may be arranged such that emitted light is resonated in a direction orthogonal to a direction between the first electrode 108 and the second electrode 110.

In one embodiment, the resonating structures may thus be formed at a bottom surface and a top surface of the active layer 106, such that emitted light resonates in an up-down direction in a vertical stack formed by the light-emitting device 100. The resonating structure may thus be achieved by sequentially forming one or more layers below the active layer 106 and above the active layer 106, respectively.

In another embodiment shown in Figs 8a-b, horizontal sides of the active layer 106 are instead designed to form resonating structures. Fig. 8b shows a cut-out of the device between the planes A and B indicated in Fig. 8a. Fig 8b also shows in more detail how the resonating structure is formed.

In the device 100 illustrated in Figs 8a-b, an inorganic metal oxide with high refractive index can provide a distributed feedback optical resonator structure. In this embodiment, the OG-OLET topology of Fig. 2b is extended in order to build a resonating structure at the sides of the OLET channel.

In this embodiment, an inorganic metal oxide used as ETL 106c may be used both as a transporting layer as well as a light feedback structure. Inorganic metal oxides have high electron mobility over 10 cm²/Vs as well as high refractive index compared to organic materials, which makes the use of an inorganic metal oxide especially suitable in forming a laser from the topology of the light-emitting device 100. The metal oxide layer will therefore not only provide high lateral electron mobility, but it will also induce a lateral guiding path in which the light emitted nearby by the EML 106b can get trapped and wave-guided. Light trapping in the metal oxide is facilitated by this layer presenting a higher refractive index, n, than the surrounding insulating layer 114 and the other transport and emissive layers of the active layer 106. For example, IGZO has a *n=* 2.0 at 630nm, whereas an organic semiconductor have a n=1.7 at 630 nm, Al₂O₃ (gate insulating material) has 1.76, and SiO₂ (gate insulating material) has 1.46. The higher the difference in refractive index between the metal oxide and the surrounding materials, the more light will be trapped in the horizontal waveguide formed by the metal oxide.

This waveguide may then be further laterally patterned with a periodic structure at the horizontal sides of the OLET channel to provide a feedback structure. A periodic spacing can be adjusted to a quarter of the emission wavelength (λ/4) in order to cause a high reflection of light of the emission wavelength λ back into the waveguide. This resonating structure may yield a concentration of a narrow set of wavelengths inside the waveguide. By leaking out of the waveguide, the concentrated light will then trigger stimulated emission in the EML 106b above the waveguide to obtain a lasing behavior.

Hereinafter, two exemplifying embodiments will be described in detail. However, these exemplifying embodiments are given only as a detailed discussion of possible implementation and should not be intended to in any way limit the scope of protection defined by the appended claims.

### Example 1

OG-OLET devices with the topologies shown in Fig. 2b were prepared. The devices were processed on ₂×₂ cm² substrates made of heavily n-doped Si wafer acting as common first gate layer. The surface of the Si was covered with 125 nm-thick thermally grown SiO₂ dielectric layer. A 50 nm-thick molybdenum layer was vacuum deposited and patterned via lift-off to form a second gate layer. A 100 nm-thick Al₂O₃ gate insulating layer was additionally formed by atomic layer deposition (ALD) at 150 °C. Finally, a last photolithography step was done to etch the Al₂O₃ layer and form a via contact to the second gate layer. The samples fabricated to this stage are referred to below as the OG-substrates.

The OG-substrates were successively cleaned with acetone and isopropanol in an ultra-sonication bath at 60 °C. The pre-cleaned substrates were treated by a UV-Os flux for 15 min. Next, n-tetradecylphosphonic acid self-assembled monolayers (SAM) were formed on the surface of the dielectric by immersing the substrates into 5 × 10⁻³ M solution in 2-propanol. After 19 hours, the OG-substrates were additionally rinsed with 2-propanol and baked on a hotplate for 10 min. The contact angle of the SAM-treated substrates was around 110°. The organic layers were then thermally evaporated on OG-substrates in a high vacuum chamber with a base pressure below 1 × 10⁻⁷ Torr. The devices comprised a multilayer stack with organic active layers composed of DNTT (20 nm) as HTL, Alq₃ (10 nm)/1.4% DCJTB:Alq₃ (20 nm)/Alq₃ (10 nm) as EML, DFH-4T (30 nm) as ETL. During the deposition of DNTT and DFH-4T, the substrate temperature was kept at 80°C and 100°C, respectively. On the other hand, the substrates were not heated up during the evaporation of Alq₃ and DCJTB layers. The growth rates were 0.3 Å s⁻¹ for DNTT and DFH-4T, 1 Å s⁻¹ for Alq₃, and 0.015 Å s⁻¹ for DCJTB. For both electron and hole source electrodes, 60 nm-thick gold layers were vacuum deposited with fine metal masks aligned on the underlying second gate layer. The evaporation rate was 1 Å s⁻¹ for Au and the substrate temperature was kept at -5°C. The hole contact was formed on the DNTT layer and the electron contact was on the DFH-4T layer with an asymmetric configuration as in Fig. 2b in order to achieve an effective charge injection into the transporting layers. The channel width and length were 47600 µm and 200 µm, respectively. To accommodate such width over a reasonable area, the device was structured with an interdigitated shape as shown in Fig. 3a.

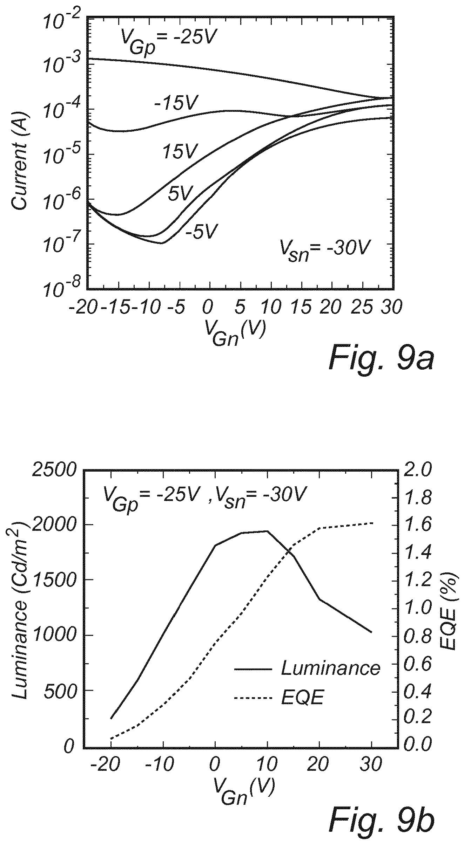

The results obtained on the OG-OLET device with unpatterned active layer such as in Fig. 2b is discussed first. The thin film transistor mobilities of the HTL (DNTT) and of the ETL (DFH-4T) have been independently measured and are 1.5 cm²/Vs and 0.3 cm²/Vs, respectively. Although the n-type mobility is 5 times less than the p-type, there exist a broad bias window where the current crossing the OG-OLET is characterized by a hole-electron balance. This is inferred from Fig. 9a that shows the transfer curves of the red-emitting OG-OLET as a function of the first gate bias (V_{Gn}) at a fixed bias to the second Gate (V_{Gp}) and and the first electrode (V_{Sn}) which acts as electron source. During the measurements, the second electrode (V_{Sp}) which acts as hole source is grounded and defines the reference voltage of the device (V_{Sp} = 0 V). When a positive bias is applied to the second gate (V_{Gp} > 0), only electron current flows through the DFH-4T layer and no light emission is detected while sweeping the first Gate bias V_{Gn}. However, as a negative bias V_{Gp} < -10 V is applied to the second gate, the OG-OLET shows ambipolar characteristics and red emission is clearly observed with naked eyes. Especially, for V_{Gp} = -15 V on the second gate, the device shows an interesting current-voltage characteristic with a local maximum in current located at V_{Gn} = 5 V on the first gate. This local maximum is assigned to a balance in hole-electron currents. The observation of such a peak in the transfer curve characteristic of balanced transport has not been observed in previously reported OLETs.

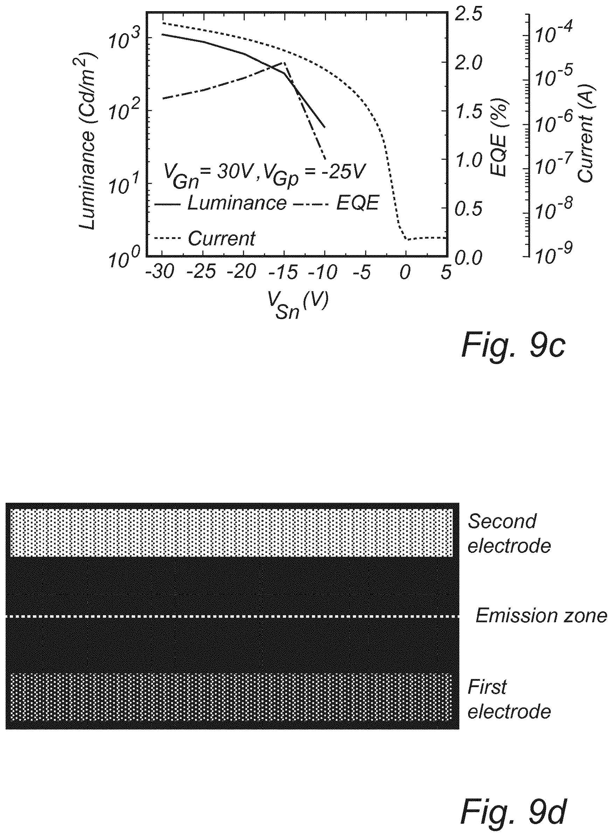

The OG-OLET emits red-light with an intensity that depends on the OG biases. Figs 9b and 9c present the corresponding brightness and EQE as a function of V_{Gn} and V_{Sn}, respectively. When negative biases are applied to both gates and to the first electrode, V_{Sn}, the device behaves as a single gate OLET does: A hole-only current crosses the whole channel and recombines with electrons in the direct vicinity of the first electrode, giving rise to light emission at the edge of the contact. This is reminiscent of single gate OLETs, and results in low brightness of 250 cd m⁻² and EQE of 0.1%. On the other hand, when gate biases of the OG-OLET device are adjusted to favor transport of both carrier species in a balanced manner (e.g. V_{Gp} < 0 and V_{Gn} > 0), the emission zone is shifted to the center of the channel, on top of the gate overlapping line, as can be seen in Fig. 9d. This emissive zone is located very far from the metal electrodes. The width of the emission zone is around 7 µm. It is important to note that the emission zone does not shift when sweeping V_{Gn} > 0 under fixed biases on V_{Gp} < 0 and V_{Sn} < 0. As a result, the light output of the OG-OLET is enhanced by reducing the exciton quenching at the electrodes. The brightness and EQE are 1998 cd m⁻² and 1.2% at 10 V, and 1000 cd m⁻² and 1.6% at 30 V as shown in Fig. 9b. In consequence, contrarily to most OLET devices previously reported, the device presented here keeps a high efficiency at the luminance over 2000 cd m⁻². If the 1931 Commission Internationale de l'Éclairage (CIE) photopic luminosity function is taken into account, the red emission with a luminance of 2000 cd m⁻² corresponds to a green emission with a luminance over 6000 cd m⁻². In addition, the red-emitting OG-OLETs functions with low operating voltage at 10 V of V_{Gn}, -25 V of V_{Gp}, and -30 of Vₛₙ, which is the lowest driving voltage among the reported OLETs. OLETs previously reported are usually operated well over ± 100 V of Vₙ as listed in Table 1.

**Table 1: The electrical and optical characteristics of high performance OLETs.**

| **Reference** | **Ref1** | **Ref2** | **Ref3** | **Ref4** | **Ref5** | **Invention** |
|---|---|---|---|---|---|---|
| Device Architecture | Split gate | Split gate | Single gate | Single gate | Single gate + nonplanar electrodes | Overlapping gates |
| Organic layer | Multilayer | Single | Multilayer | Single | Multilayer | Multilayer |
| Emission area | Not reported | 4µm × 1mm | 2µm × 20cm | not reporte d | 5µm × 88mm | 5µm × 47.6mm |
| Color (material) | Green (Alq₃) | Green (F8BT) | Red (Alq₃:D CM) | Green (F8BT) | Yellow (SY) | Red (Alq₃:Dcjt b) |
| The gaplength of the split-gate | 1 µm | 4 µm | - | - | - | zero |
| Width/ Length | - | 1 mm/24 µm | 20 cm/150 µm | 4 mm/20 µm | - | 47.6mm/ 200pm |
| Light output | Not reported | 2.75 W/m² | 230 nW | Not reported | Not reported | 7.98 W/m² |
| Max EQE (brightness, Operation voltage, current) | 0.025% (110 cd/m²,Vss = 30 V, V_{Gn} = 30 V, V_{Gp} = 60 V, 10⁻² A) | 1.3% (609 cd/m²,Vss = -150 V, V_{Gn} = 0V, V_{Gp} = - 150 V, 3 × 10⁻⁷ A) | 5.5% (V_{d} = 90 V, V_{G} = 30 V, 2.5 × 10⁻⁷ A) | 8.16% (V_{d} = 100 V, V_{G} = 30 V, 10⁻⁶ A) | 1.86% (0.5 cd/m², V_{d} = 100 V, V_{G} = 75 V, 10⁻⁶ A) | 6.82% (630 cd/m², V_{Gn} = 26 V, V_{Gp} = - 30 V, V_{Sn} = -35 V, 3.04 × 10^{- 5} A) |
| Max Brightness (EQE, Operation voltage, current) | 110 cd/m² (0.025%, V_{SS} = 30 V, V_{Gn} = 30 V, V_{Gp} = 60 V, 10⁻² A) | 609 cd/m² (1.3%, V_{SS} = - 150 V, V_{Gn} = 0 V, V_{Gp} = - 150 V, 3 × 10⁻⁷ A) | - | | 2065 cd/m² (0.06%, V_{d} = 100 V, V_{G} = -100 V, 0.008 A) | 1085 cd/m² (4.9%, V_{Gn} = 30 V, V_{Gp} = - 30 V, V_{Sn} = -35 V, 7.03 × 10^{- 5} A) |

The references used in Table 1 are as follows:
Ref1: N. Suganuma et al, "Organic light-emitting transistors with split-gate structure and PN-hetero-boundary carrier recombination sites", Organic Electronics, Vol. 9, pages 834-838 (2008)
Ref2: B.B.Y. Hsu et al: "Split-Gate Organic Field-Effect Transistors: Control Over Charge Injection and Transport", Advanced Materials, Vol. 22, pages 4649-4653 (2010)
Ref3: R. Capelli et al: "Organic light-emitting transistors with an efficiency that outperforms the equivalent light-emitting diodes", Nature Materials, Vol. 9, pages 496-503 (2010)
Ref4: M.C. Gwinner et al: "Highly Efficient Single-Layer Polymer Ambipolar Light-Emitting Field-Effect Transistors", Advanced Materials, Vol. 24, pages 2728-2734 (2012)
M. Ullah et al, "Simultaneous Enhancement of Brightness, Efficiency, and Switching in RGB Organic Light Emitting Transistors", Advanced Materials, Vol. 25, pages 6213-6218 (2013)

Further device downscaling and dielectric engineering can lead to even lower operation voltages. To operate at low voltages, it is known in the state of the art how the channel length can be scaled to smaller dimensions, down to a few micron, or even submicron such as 200 nm. Also the thickness of the dielectrics can be scaled down. It is known in the state of the art how to achieve thicknesses down to a few nanometer by technologies as chemical vapor deposition (CVD) or atomic layer deposition (ALD).

As shown in Fig. 9c, under fixed biases on V_{Gn} = 30 V and V_{Gp} = -25 V, the current begins to increase from 2 × 10⁻⁹ A at V_{Sn} = -1 V and reaches 2 × 10⁻⁴ A at V_{Sn} = -30 V. Meanwhile, the detectable red-light emission turns on at V_{Sn} = -10 V, corresponding to 59 cd m⁻² and 1% of EQE. The light intensity gradually increases to 1096 cd m⁻² with V_{Sn} decreasing to -30 V. In parallel, EQE shows a peak value of 2.01% at V_{Sn} = -15 V and decreases to 1.65% at -30 V. The results indicate that OG-OLETs topology simultaneously achieves high light-output and high EQE. The overlapping-gates are able to independently control electron and hole transport and achieve current balance in spite of the difference in charge carrier mobility of the two organic semiconductors. Yet, the output current curve shown in Fig. 9c and the EQE peak at moderate currents show that at higher biases, a fraction of the current is not participating in the light emission. Instead, this current follows a leakage path and flows from the hole injecting second electrode, through the DNTT HTL layer, and into the first electrode. The device discussed in Example 2 is using a patterned HTL that brings a significant reduction of the leakage current.

### Example 2

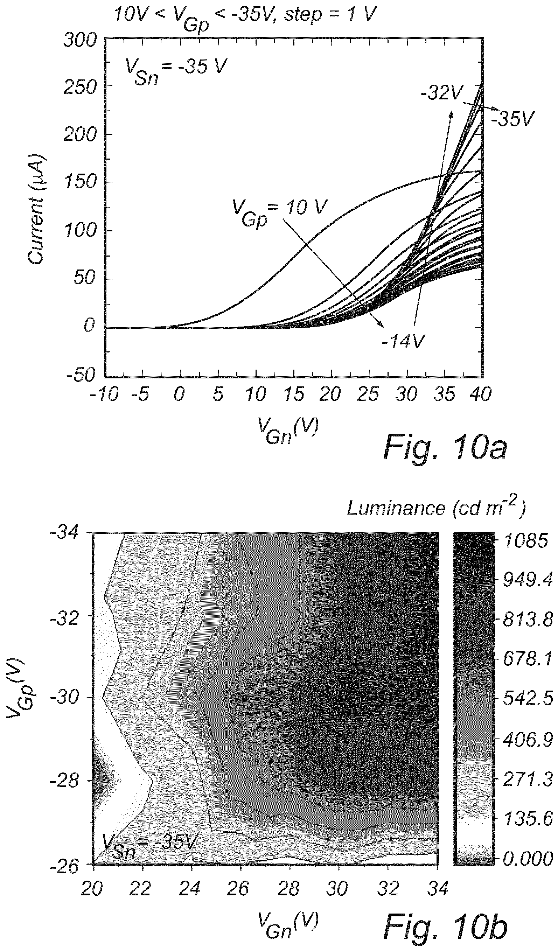

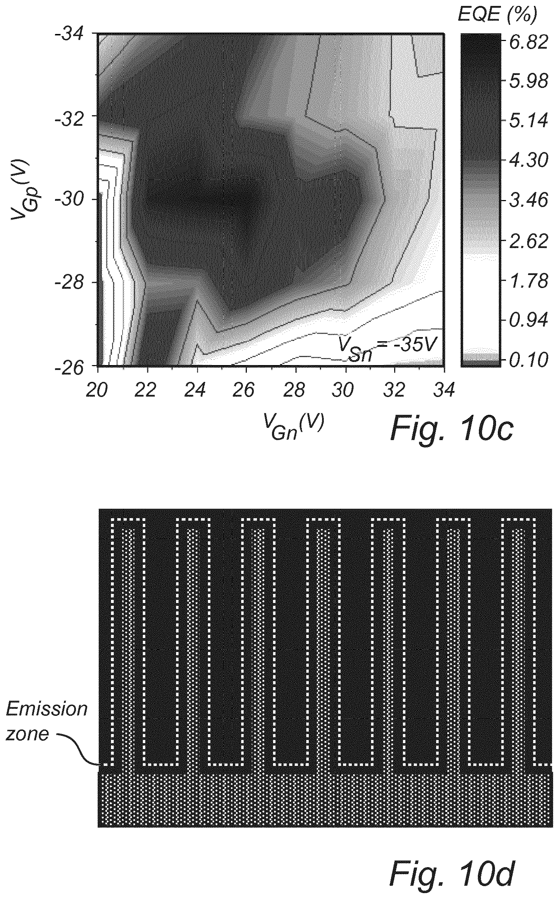

An OG-OLET device with patterned HTL as depicted in Fig. 2c was prepared. The device structure of the organic semiconductors in the OG-OLET is similar with the device structure in example 1. The only difference is that the HTL was patterned with a metal mask during the thermal evaporation. Fig. 10a shows the transfer curves of the red-emitting OG-OLET with patterned HTL that are totally different from the characteristics of the device wherein the HTL is not patterned. The high parasitic leakage current over 10⁻⁴ A at V_{Gp} < -15 V, V_{Gn} < 0, and V_{Sn} = -30 V in Fig. 9a is completely reduced in the device with patterned HTL. The transfer curves show a current below 10⁻¹⁰ A when 9 V < V_{Gp} < -35 V and V_{Sn} = -35 V, while sweeping V_{Gn}. As a result, the on/off ratio of the device with patterned HTL significantly increases to be 10⁷, that is 10⁶ times higher than the device wherein the HTL is not patterned. The transfer curves of the red OG-OLET with patterned HTL in Fig. 10a show three different trends as a function of V_{Gp} and V_{Gn}, relating to the hole-electron charge balance. When a positive bias is applied on the second gate (V_{Gp} > 0) and V_{Sn} = -35 V on the first electrode, the current starts to increase at a negative V_{Gn} and shows a saturation behavior around 40 V of the V_{Gn}. No light emission is observed. In these conditions, a leakage electron current flows through the DFH-4T layer (ETL) across the entire channel. The current saturates because V_{Gp} is fixed to positive values that defines a limited accumulation in a fraction of the channel. When V_{Gp} decreases from 10 V to - 14 V, the current gradually decreases since leakage electron current is deactivated on top of the second gate. No light emission is observed in this range that is still dominated by leakage electron current. But further decreasing V_{Gp} below -14 V brings a current increase that marks the onset of recombination current. As a result, bright red light is clearly observed. At low V_{Gp} below -30 V, the current shows a local maximum and then slightly decreases again due to imbalance of hole-electron currents. Figs 10b and 10c show contour maps of luminance and EQE values as a function of V_{Gn} and V_{Gp} (with V_{Sn} = -35 V), and an optical image of the emitting OG-OLET is illustrated in Fig. 10d. Under V_{Gn} = 30 V, V_{Gp} = -30 V, and V_{Sn} = -35 V, the device shows a maximum luminance about 1085 cd m⁻², which corresponds to 4.9% of EQE. The maximum EQE of 6.82% is achieved at 630 cd m⁻² under V_{Gn} = 26 V, V_{Gp} = -30 V, and V_{Sn} = -35 V. The reduction of the parasitic leakage by patterning one of the transport layers leads to a boost in EQE over 6% which is the record high value among the reported red-emitting OLETs as listed in Table 1. This result confirms that patterning the active layers in OG-OLETs gives a way to further increase device efficiency by cutting down parasitic leakage current.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A light-emitting device (100), comprising:
an active layer (106) comprising at least one semiconductor layer (106a-c) for transport of charge carriers and emission of light upon radiative recombination of charge carriers of a first type and a second type,
a first gate layer (102), which is arranged to control density of charge carriers of the first type in the active layer (106),
a second gate layer (104), which is arranged to control density of charge carriers of the second type in the active layer (106),
wherein a first insulating layer (112) is arranged on the first gate layer (102) and the second gate layer (104) forms a pattern on the first insulating layer (112),
wherein a second insulating layer (114) is arranged on the second gate layer (104),
wherein the active layer (106) is arranged on the first (112) and second insulating layers (114), and
wherein the first gate layer (102) and the second gate layer (104) are configured to independently accumulate the respective type of charge carrier, enabling opening of two balanced unipolar channels that independently drive charge carriers into a zone of the active layer where radiative recombination occurs.

2. The light-emitting device according to claim 1, wherein the second gate layer (104) forms a pattern above the first gate layer (102) such that at least part of the second gate layer (104) overlaps the first gate layer (102).

3. The light-emitting device according to claim 2, wherein the second gate layer (104) forms a pattern above the first gate layer (102) such that the second gate layer (104) overlaps only part of the first gate layer (102).

4. The light-emitting device according to any one of claims 1-3, further comprising a first electrode (108) in contact with the active layer (106) for injecting charge carriers of the first type into the active layer (106) and a second electrode (110) in contact with the active layer (106) for injecting charge carriers of the second type into the active layer (106).

5. The light-emitting device according to claim 4, wherein the first electrode (108) is arranged in contact with a first semiconductor layer (106c) of the active layer (106) and the second electrode (110) is arranged in contact with a second semiconductor layer (106a) of the active layer (106).

6. The light-emitting device according to claim 4 or 5, wherein the active layer (106) comprises at least a first semiconductor layer (106c) for transport of charge carriers of the first type and a second semiconductor layer (106a) for transport of charge carriers of the second type.

7. The light-emitting device according to claim 6, wherein the active layer (106) further comprises a third semiconductor layer (106b) for the radiative recombination of charge carriers of the first and second types.

8. The light-emitting device according to claim 6 or 7, wherein at least one of the first semiconductor layer (106c) and the second semiconductor layer (106a) forms a pattern to extend in a direction from a first one of the first or the second electrode (108; 110) towards a second one of the first or the second electrode (108; 110), wherein the pattern of the at least one of the first semiconductor layer (106c) and the second semiconductor layer (106a) extends to overlap an edge (105) of the second gate layer (104) and ends such that the second one of the first or the second electrode (108; 110) and the at least one of the first semiconductor layer (106c) and the second semiconductor layer (106a) do not overlap.

9. The light-emitting device according to claim 7, wherein the third semiconductor layer (106b) forms a pattern to extend on opposite sides of an edge (105) of the second gate layer (104) between the first and second electrode (108, 110) such that at least one of the first and second electrode (108, 110) and the third semiconductor layer (106b) do not overlap.

10. The light-emitting device according to any one of the preceding claims, wherein the first gate layer (102) forms a pattern on a substrate (101), such that an overlap of the first gate layer (102) and the second gate layer (104) is defined by an edge (103) of the first gate layer (102) and an edge (105) of the second gate layer (104).

11. The light-emitting device according to any one of the preceding claims, wherein the second gate layer (104) comprises an edge (105) arranged above the first gate layer (102), wherein said edge (105) defines a gate overlapping line (OL) along the edge (105) and wherein at least the second gate layer (104) forms a pattern so that a non-straight gate overlapping line (OL) is defined.

12. The light-emitting device according to any one of the preceding claims, wherein the second gate layer (104) comprises an edge (105) arranged above the first gate layer (102), wherein said edge (105) defines a gate overlapping line (OL) along the edge (105) and wherein at least the second gate layer (104) forms a pattern to define the gate overlapping line (OL) in relation to the active layer such that the active layer (106) is arranged discontinuously above the gate overlapping line (OL).

13. The light-emitting device according to any one of the preceding claims, wherein the second gate layer (104) comprises an edge (105) arranged above the first gate layer (102), wherein said edge (105) defines a gate overlapping line (OL) along the edge (105) and the first gate layer (102) and the second gate layer (104) each form a pattern including protrusions, such that protrusions of the first gate layer pattern and protrusions of the second gate layer pattern extend towards each other when viewed from above the first and second gate layers (102, 104) such that an overlap between the first gate layer (102) and the second gate layer (104) is formed at ends of the protrusions defining a discontinuous gate overlapping line (OL).

14. The light-emitting device according to any one of the preceding claims, wherein the active layer (106) extends between a first and a second electrode (108, 110) and wherein the light-emitting device further comprises resonating structures at opposite sides of the active layer (106) for resonating emitted light in a direction which is orthogonal to a direction between the first and the second electrode (108, 110).

15. A light-emitting device for stimulated emission of radiation, said device comprising:
an active layer (106) comprising at least one semiconductor layer (106a-c) for transport of charge carriers to a radiative recombination zone,
a first gate layer (102), which is arranged to control density of charge carriers of a first type in the active layer (106),
a second gate layer (104), which is arranged to control density of charge carriers of a second type in the active layer (106),
wherein an insulating layer (112) is arranged on the first gate layer (102) and the second gate layer (104) forms a pattern on the insulating layer (112),
wherein the active layer (106) is arranged on the first (102) and second gate layers (104),
wherein the radiative recombination zone is formed in the active layer (106) between a first electrode (108) for injecting charge carriers of the first type into the active layer (106) and a second electrode (110) for injecting charge carriers of the second type into the active layer (106), and **characterized in that**
the light-emitting device is further provided with a periodic structure of alternating high refractive index region and low refractive index region along opposite sides of the active layer (106) between the first and the second electrode (108, 110), said periodic structure providing a feedback of light emitted from the radiative recombination zone back into the radiative recombination zone for stimulating emission of radiation.

## Patentansprüche

1. Licht emittierende Vorrichtung (100), umfassend:
eine aktive Schicht (106), die mindestens eine Halbleiterschicht (106a-c) zum Transport von Ladungsträgern und zur Emission von Licht bei strahlender Rekombination von Ladungsträgern einer ersten Art und einer zweiten Art umfasst,
eine erste Gate-Schicht (102), die dazu angeordnet ist, die Dichte von Ladungsträgern der ersten Art in der aktiven Schicht (106) zu steuern,
eine zweite Gate-Schicht (104), die dazu angeordnet ist, die Dichte von Ladungsträgern der zweiten Art in der aktiven Schicht (106) zu steuern,
wobei eine erste Isolierschicht (112) auf der ersten Gate-Schicht (102) angeordnet ist, und die zweite Gate-Schicht (104) ein Muster auf der ersten Isolierschicht (112) bildet,
wobei eine zweite Isolierschicht (114) auf der zweiten Gate-Schicht (104) angeordnet ist,
wobei die aktive Schicht (106) auf der ersten (112) und der zweiten Isolierschicht (114) angeordnet ist, und
wobei die erste Gate-Schicht (102) und die zweite Gate-Schicht (104) dazu konfiguriert sind, die jeweilige Art von Ladungsträger unabhängig anzusammeln, wodurch die Öffnung von zwei ausgewogenen einpoligen Kanälen ermöglicht wird, die Ladungsträger unabhängig in einen Bereich der aktiven Schicht treiben, in dem eine strahlende Rekombination stattfindet.

2. Licht emittierende Vorrichtung nach Anspruch 1, wobei die zweite Gate-Schicht (104) ein Muster über der ersten Gate-Schicht (102) bildet, so dass sich mindestens ein Teil der zweiten Gate-Schicht (104) mit der ersten Gate-Schicht (102) überlappt

3. Licht emittierende Vorrichtung nach Anspruch 2, wobei die zweite Gate-Schicht (104) ein Muster über der ersten Gate-Schicht (102) bildet, so dass sich die zweite Gate-Schicht (104) nur teilweise mit der ersten Gate-Schicht (102) überlappt.

4. Licht emittierende Vorrichtung nach einem der Ansprüche 1 bis 3, ferner umfassend eine erste Elektrode (108) in Kontakt mit der aktiven Schicht (106) zum Injizieren von Ladungsträgern der ersten Art in die aktive Schicht (106) und eine zweite Elektrode (110) in Kontakt mit der aktiven Schicht (106) zum Injizieren von Ladungsträgern der zweiten Art in die aktive Schicht (106).

5. Licht emittierende Vorrichtung nach Anspruch 4, wobei die erste Elektrode (108) in Kontakt mit einer ersten Halbleiterschicht (106c) der aktiven Schicht (106) angeordnet ist und die zweite Elektrode (110) in Kontakt mit einer zweiten Halbleiterschicht (106a) der aktiven Schicht (106) angeordnet ist.

6. Licht emittierende Vorrichtung nach Anspruch 4 oder 5, wobei die aktive Schicht (106) mindestens eine erste Halbleiterschicht (106c) zum Transport von Ladungsträgern der ersten Art und eine zweite Halbleiterschicht (106a) zum Transport von Ladungsträgern der zweiten Art umfasst.

7. Licht emittierende Vorrichtung nach Anspruch 6, wobei die aktive Schicht (106) ferner eine dritte Halbleiterschicht (106b) zur strahlenden Rekombination von Ladungsträgern der ersten und der zweiten Art umfasst.

8. Licht emittierende Vorrichtung nach Anspruch 6 oder 7, wobei mindestens eine von der ersten Halbleiterschicht (106c) und der zweiten Halbleiterschicht (106a) ein Muster bildet, um sich in einer Richtung von einer von der ersten oder der zweiten Elektrode (108; 110) in Richtung auf eine zweite von der ersten oder der zweiten Elektrode (108; 110) zu erstrecken, wobei sich das Muster der mindestens einen von der ersten Halbleiterschicht (106c) und der zweiten Halbleiterschicht (106a) erstreckt, um sich mit einem Rand (105) der zweiten Gate-Schicht (104) zu überlappen, und derart endet, dass sich die zweite von der ersten oder der zweiten Elektrode (108; 110) und die mindestens eine von der ersten Halbleiterschicht (106c) und der zweiten Halbleiterschicht (106a) nicht überlappen.

9. Licht emittierende Vorrichtung nach Anspruch 7, wobei die dritte Halbleiterschicht (106b) ein Muster bildet, um sich auf gegenüberliegenden Seiten eines Randes (105) der zweiten Gate-Schicht (104) zwischen der ersten und der zweiten Elektrode (108, 110) zu erstrecken, so dass sich mindestens eine von der ersten und der zweiten Elektrode (108, 110) und die dritte Halbleiterschicht (106b) nicht überlappen.

10. Licht emittierende Vorrichtung nach einem der vorhergehenden Ansprüche, wobei die erste Gate-Schicht (102) ein Muster auf einem Substrat (101) bildet, so dass eine Überlappung der ersten Gate-Schicht (102) und der zweiten Gate-Schicht (104) durch einen Rand (103) der ersten Gate-Schicht (102) und einen Rand (105) der zweiten Gate-Schicht (104) definiert ist.

11. Licht emittierende Vorrichtung nach einem der vorhergehenden Ansprüche, wobei die zweite Gate-Schicht (104) einen Rand (105) umfasst, der über der ersten Gate-Schicht (102) angeordnet ist, wobei der Rand (105) eine Gate-Überlappungslinie (OL) entlang des Randes (105) definiert, und wobei mindestens die zweite Gate-Schicht (104) ein Muster bildet, so dass eine ungerade Gate-Überlappungslinie (OL) definiert ist.

12. Licht emittierende Vorrichtung nach einem der vorhergehenden Ansprüche, wobei die zweite Gate-Schicht (104) einen Rand (105) umfasst, der über der ersten Gate-Schicht (102) angeordnet ist, wobei der Rand (105) eine Gate-Überlappungslinie (OL) entlang des Randes (105) definiert, und wobei mindestens die zweite Gate-Schicht (104) ein Muster bildet, um die Gate-Überlappungslinie (OL) mit Bezug auf die aktive Schicht zu definieren, so dass die aktive Schicht (106) über der Gate-Überlappungslinie (OL) diskontinuierlich angeordnet ist.

13. Licht emittierende Vorrichtung nach einem der vorhergehenden Ansprüche,
wobei die zweite Gate-Schicht (104) einen Rand (105) umfasst, der über der ersten Gate-Schicht (102) angeordnet ist, wobei der Rand (105) eine Gate-Überlappungsline (OL) entlang des Randes (105) definiert, und die erste Gate-Schicht (102) und die zweite Gate-Schicht (104) jeweils ein Muster bilden, das Vorsprünge umfasst, so dass sich die Vorsprünge des ersten Gate-Schichtmusters und die Vorsprünge des zweiten Gate-Schichtmusters aufeinander zu erstrecken, von oberhalb der ersten und der zweiten Gate-Schicht (102, 104) aus gesehen, so dass sich eine Überlappung zwischen der ersten Gate-Schicht (102) und der zweiten Gate-Schicht (104) an den Enden der Vorsprünge bildet, die eine diskontinuierliche Gate-Überlappungslinie (OL) definiert.

14. Licht emittierende Vorrichtung nach einem der vorhergehenden Ansprüche, wobei sich die aktive Schicht (106) zwischen einer ersten und einer zweiten Elektrode (108, 110) erstreckt, und wobei die Licht emittierende Vorrichtung ferner Resonanzstrukturen auf gegenüberliegenden Seiten der aktiven Schicht (106) umfasst, um emittiertes Licht in einer Richtung mitschwingen zu lassen, die zu einer Richtung zwischen der ersten und der zweiten Elektrode (108, 110) orthogonal ist.

15. Licht emittierende Vorrichtung zur stimulierten Emission von Strahlung, wobei die Vorrichtung umfasst:
eine aktive Schicht (106), die mindestens eine Halbleiterschicht (106a-c) zum Transport von Ladungsträgern zu einem strahlenden Rekombinationsbereich umfasst,
eine erste Gate-Schicht (102), die dazu angeordnet ist, die Dichte von Ladungsträgern der ersten Art in der aktiven Schicht (106) zu steuern,
eine zweite Gate-Schicht (104), die dazu angeordnet ist, die Dichte von Ladungsträgern der zweiten Art in der aktiven Schicht (106) zu steuern,
wobei eine erste Isolierschicht (112) auf der ersten Gate-Schicht (102) angeordnet ist, und die zweite Gate-Schicht (104) ein Muster auf der Isolierschicht (112) bildet,
wobei die aktive Schicht (106) auf der ersten (102) und der zweiten Gate-Schicht (104) angeordnet ist,
wobei der strahlende Rekombinationsbereich in der aktiven Schicht (106) zwischen der ersten Elektrode (108) zum Injizieren von Ladungsträgern der ersten Art in die aktive Schicht (106) und einer zweiten Elektrode (110) zum Injizieren von Ladungsträgern der zweiten Art in die aktive Schicht (106) gebildet ist, und
**dadurch gekennzeichnet, dass** die Licht emittierende Vorrichtung ferner mit einer periodischen Struktur von abwechselnden Regionen mit hohem Brechungsindex und Regionen mit niedrigem Brechungsindex entlang gegenüberliegender Seiten der aktiven Schicht (106) zwischen der ersten und der zweiten Elektrode (108, 110) versehen ist, wobei die periodische Struktur eine Rückmeldung von Licht, das von dem strahlenden Rekombinationsbereich zurück in den strahlenden Rekombinationsbereich emittiert wird, zum Stimulieren einer Strahlungsemission bereitstellt.

## Revendications

1. Dispositif électroluminescent (100), comprenant :
une couche active (106) comprenant au moins une couche semi-conductrice (106a-c) pour le transport de porteurs de charge et l'émission de lumière lors de la recombinaison radiative de porteurs de charge d'un premier type et d'un deuxième type,
une première couche de grille (102), qui est agencée pour contrôler la densité de porteurs de charge du premier type dans la couche active (106),
une deuxième couche de grille (104), qui est agencée pour contrôler la densité des porteurs de charge du deuxième type dans la couche active (106),
dans lequel une première couche isolante (112) est agencée sur la première couche de grille (102) et la deuxième couche de grille (104) forme un motif sur la première couche isolante (112),
dans lequel une deuxième couche isolante (114) est agencée sur la deuxième couche de grille (104),
dans lequel la couche active (106) est agencée sur les première (112) et deuxième couches isolantes (114), et
dans lequel la première couche de grille (102) et la deuxième couche de grille (104) sont configurées pour accumuler indépendamment le type respectif de porteur de charge, permettant l'ouverture de deux canaux unipolaires équilibrés qui entraînent indépendamment des porteurs de charge dans une zone de la couche active où se produit une recombinaison radiative.

2. Dispositif électroluminescent selon la revendication 1, dans lequel la deuxième couche de grille (104) forme un motif au-dessus de la première couche de grille (102) de telle sorte qu'au moins une partie de la deuxième couche de grille (104) se superpose à la première couche de grille (102).

3. Dispositif électroluminescent selon la revendication 2, dans lequel la deuxième couche de grille (104) forme un motif au-dessus de la première couche de grille (102) de telle sorte que la deuxième couche de grille (104) se superpose à seulement une partie de la première couche de grille (102).

4. Dispositif électroluminescent selon une quelconque des revendications 1 à 3, comprenant en outre une première électrode (108) en contact avec la couche active (106) pour injecter des porteurs de charge du premier type dans la couche active (106) et une deuxième électrode (110) en contact avec la couche active (106) pour injecter des porteurs de charge du deuxième type dans la couche active (106).

5. Dispositif électroluminescent selon la revendication 4, dans lequel la première électrode (108) est disposée en contact avec une première couche semi-conductrice (106c) de la couche active (106) et la deuxième électrode (110) est disposée en contact avec une deuxième couche semi-conductrice (106a) de la couche active (106).

6. Dispositif électroluminescent selon la revendication 4 ou 5, dans lequel la couche active (106) comprend au moins une première couche semi-conductrice (106c) pour le transport de porteurs de charge du premier type et une deuxième couche semi-conductrice (106a) pour le transport de porteurs de charge du deuxième type.

7. Dispositif électroluminescent selon la revendication 6, dans lequel la couche active (106) comprend en outre une troisième couche semi-conductrice (106b) pour la recombinaison radiative de porteurs de charge des premier et deuxième types.

8. Dispositif électroluminescent selon la revendication 6 ou 7, dans lequel au moins une de la première couche semi-conductrice (106c) et de la deuxième couche semi-conductrice (106a) forme un motif destiné à s'étendre dans une direction allant d'une première de la première ou la deuxième électrode (108 ; 110) vers une deuxième de la première ou la deuxième électrode (108 ; 110), dans lequel le motif d'au moins une de la première couche semi-conductrice (106c) et de la deuxième couche semi-conductrice (106a) s'étend pour se superposer à un bord (105) de la deuxième couche de grille (104) et se termine de telle sorte que la deuxième de la première ou la deuxième électrode (108 ; 110) et au moins une de la première couche semi-conductrice (106c) et de la deuxième couche semi-conductrice (106a) ne se superposent pas.

9. Dispositif électroluminescent selon la revendication 7, dans lequel la troisième couche semi-conductrice (106b) forme un motif destiné à s'étendre sur les côtés opposés d'un bord (105) de la deuxième couche de grille (104) entre la première et la deuxième électrode (108, 110) de telle sorte qu'au moins une de la première et la deuxième électrode (108, 110) et la troisième couche semi-conductrice (106b) ne se superposent pas.

10. Dispositif électroluminescent selon une quelconque des revendications précédentes, dans lequel la première couche de grille (102) forme un motif sur un substrat (101), de telle sorte qu'une superposition de la première couche de grille (102) et de la deuxième couche de grille (104) soit définie par un bord (103) de la première couche de grille (102) et un bord (105) de la deuxième couche de grille (104).

11. Dispositif électroluminescent selon une quelconque des revendications précédentes, dans lequel la deuxième couche de grille (104) comprend un bord (105) disposé au-dessus de la première couche de grille (102), dans lequel ledit bord (105) définit une ligne de superposition de grille (OL) le long du bord (105) et dans lequel au moins la deuxième couche de grille (104) forme un motif de sorte qu'une ligne de superposition de grille non droite (OL) soit définie.

12. Dispositif électroluminescent selon une quelconque des revendications précédentes, dans lequel la deuxième couche de grille (104) comprend un bord (105) disposé au-dessus de la première couche de grille (102), dans lequel ledit bord (105) définit une ligne de superposition de grille (OL) le long du bord (105) et dans lequel au moins la deuxième couche de grille (104) forme un motif pour définir la ligne de superposition de grille (OL) par rapport à la couche active de telle sorte que la couche active (106) soit disposée de manière discontinue au-dessus de la ligne de superposition de grille (OL).

13. Dispositif électroluminescent selon une quelconque des revendications précédentes,
dans lequel la deuxième couche de grille (104) comprend un bord (105) disposé au-dessus de la première couche de grille (102), dans lequel ledit bord (105) définit une ligne de superposition de grille (OL) le long du bord (105) et la première couche de grille (102) et la deuxième couche de grille (104) forment chacune un motif comprenant des protubérances, de telle sorte que les protubérances du motif de la première couche de grille et les protubérances du motif de la deuxième couche de grille s'étendent l'une vers l'autre lorsqu'elles sont vues depuis le dessus des première et deuxième couches de grille (102, 104) de telle sorte qu'un superposition entre la première couche de grille (102) et la deuxième couche de grille (104) soit formée aux extrémités des protubérances définissant une ligne de superposition de grille discontinue (OL).

14. Dispositif électroluminescent selon une quelconque des revendications précédentes, dans lequel la couche active (106) s'étend entre une première et une deuxième électrode (108, 110) et dans lequel le dispositif électroluminescent comprend en outre des structures résonnantes sur les côtés opposés de la couche active (106) pour faire résonner la lumière émise dans une direction qui est orthogonale à une direction entre la première et la deuxième électrode (108, 110).

15. Dispositif électroluminescent pour l'émission stimulée de rayonnement, ledit dispositif comprenant :
une couche active (106) comprenant au moins une couche semi-conductrice (106a-c) pour le transport de porteurs de charge vers une zone de recombinaison radiative,
une première couche de grille (102), qui est agencée pour contrôler la densité de porteurs de charge d'un premier type dans la couche active (106) ;
une deuxième couche de grille (104), qui est agencée pour contrôler la densité de porteurs de charge d'un deuxième type dans la couche active (106),
dans lequel une couche isolante (112) est agencée sur la première couche de grille (102) et la deuxième couche de grille (104) forme un motif sur la couche isolante (112),
dans lequel la couche active (106) est agencée sur les première (102) et deuxième couches de grille (104),
dans lequel la zone de recombinaison est formée dans la couche active (106) entre une première électrode (108) pour injecter des porteurs de charge du premier type dans la couche active (106) et une deuxième électrode (110) pour injecter des porteurs de charge du deuxième type dans la couche active (106), et
**caractérisé en ce que** le dispositif électroluminescent est en outre pourvu d'une structure périodique d'une région à haut indice de réfraction et d'une région à faible indice de réfraction alternées le long des côtés opposés de la couche active (106) entre la première et la deuxième électrode (108, 110), ladite structure périodique fournissant une rétroaction de la lumière émise par la zone de recombinaison radiative vers la zone de recombinaison radiative pour stimuler l'émission de rayonnement.
